# EUROPÄISCHE PATENTSCHRIFT

(11) **EP 3 054 478 B1**
(45) Veröffentlichungstag und Bekanntmachung des Hinweises auf die Patenterteilung: **20.05.2020**
(21) Anmeldenummer: 16153896.2
(22) Anmeldetag: 02.02.2016
(51) Int. Cl.: H01L 21/67, H01L 21/68

(54) **BESTÜCKMASCHINE UND VERFAHREN ZUM BESTÜCKEN EINES TRÄGERS MIT UNGEHÄUSTEN CHIPS**
LOADING MACHINE AND METHOD FOR LOADING A SUPPORT WITH UNHOUSED CHIPS
MACHINE A PLANTER DES COMPOSANTS ET PROCEDE DESTINE A PLANTER DES PUCES SANS BOITIER SUR UN SUPPORT

(30) Priorität: 06.02.2015 DE 102015101759
(43) Veröffentlichungstag der Anmeldung: 10.08.2016
(73) Patentinhaber: ASM Assembly Systems GmbH & Co. KG, 81379 München (DE)
(72) Erfinder: Prüfer, Martin, 81476 München (DE); Ohnrich, Bernd, 81739 München (DE); Demmel, Sylvester, 83043 Bad Aibling (DE); Wörl, Manfred, 82110 Germering (DE)
(74) Vertreter: Dilg, Haeusler, Schindelmann Patentanwaltsgesellschaft mbH

(56) Entgegenhaltungen:
- EP-A2- 1 581 040
- JP-A- 2013 243 326
- US-A- 4 980 971
- US-A- 5 894 657
- US-A1- 2002 186 967
- US-A1- 2010 050 429
- US-A1- 2010 257 731
- US-A1- 2012 066 898
- US-A1- 2013 160 952

## Beschreibung

### Technisches Gebiet

Die vorliegende Erfindung betrifft allgemein das technische Gebiet der Herstellung von elektronischen Bauelementen. Die vorliegende Erfindung betrifft insbesondere eine Bestückmaschine sowie ein Verfahren zum Handhaben von ungehäusten Chips im Rahmen der Fertigung von elektronischen Bauelementen, welche jeweils zumindest einen Chip verpackt in einem Gehäuse und geeignete elektrische Anschlusskontakte aufweisen, mittels welchen der verpackte Chip elektrisch kontaktiert werden kann.

### Hintergrund der Erfindung

Bei der Fertigung von gehäusten elektronischen Bauelementen werden ungehäuste (Halbleiter-) Chips, so genannte "Bare Dies", auf einen Träger bestückt. Im Rahmen des sogenannten "embedded Wafer Level package" Prozesses (eWLP) werden dazu ein oder mehrere Chips pro Verpackung mit der aktiven Seite nach unten auf eine an dem Träger befindliche Klebefolie aufgesetzt. Anschließend wird eine Vielzahl von aufgesetzten Chips mit einer Masse aus Kunststoff vergossen, welche später das Gehäuse darstellt. Das gesamte Vergussprodukt wird dann unter hohem Druck gebacken und anschließend von dem Träger bzw. der Klebefolie gelöst. In nachfolgenden Prozess-Schritten werden die Chips dann kontaktiert, ggf. elektrisch verbunden und als elektrische Anschlusskontakte dienende Lotkugeln aufgebracht. Am Ende wird das gesamte weiterverarbeitete Vergussprodukt zu einzelnen Bauelementen zersägt.

Anschaulich ausgedrückt ist eWLP eine Gehäusebauform für integrierte Schaltungen, bei der die die elektrischen Anschlusskontakte auf einem aus Chips und Vergussmasse künstlich hergestellten Wafer erzeugt werden. Somit werden alle notwendigen Bearbeitungsschritte für das Ausbilden eines Gehäuses auf dem künstlichen Wafer durchgeführt. Dies erlaubt gegenüber den klassischen Gehäusetechnologien, bei denen das sog. "Wire Bonding" zum Einsatz kommt, die Herstellung extrem kleiner und flacher Gehäuse mit exzellenten elektrischen und thermischen Eigenschaften bei besonders niedrigen Herstellungskosten. Mit dieser Technologie können die Bauelemente beispielsweise als Ball Grid Array (BGA) hergestellt werden.

Die Handhabung der noch ungehäusten Chips erfolgt mit einer (modifizierten) Bestückmaschine, welche einen Bestückkopf aufweist, mit dem die Chips an vordefinierten Bestückpositionen auf dem Träger platziert werden. Dafür sind die Anforderungen an die Positionsgenauigkeit der Bestückung besonders hoch. Derzeit wird eine Positionsgenauigkeit bzw. Bestückgenauigkeit von 10µm/3σ gefordert, wobei σ (sigma) die Standardabweichung für die Bestückposition ist. Aufgrund der zunehmenden Miniaturisierung von elektronischen Bauelementen ist zu erwarten, dass zukünftig an die Bestückgenauigkeit noch höhere Anforderungen gestellt werden.

US 5 894 657 A beschreibt einen Bestückautomat für elektronische Komponenten. Der Automat weist einen Bestückkopf auf, welcher eine Pipette zum Koppeln einer elektronischen Komponente hat. Der Bestückkopf ist eingerichtet zum Aufnehmen der elektronischen Komponente von einem Wafer und zum Transportieren der elektronischen Komponente und Bestücken der elektronischen Komponente auf die Leiterplatte.

Der vorliegenden Erfindung liegt die Aufgabe zugrunde, eine Bestückmaschine sowie ein Verfahren zum Bestücken eines Trägers mit ungehäusten Halbleiter-Chips anzugeben, welche eine besonders hohe Bestückgenauigkeit ermöglichen.

### Zusammenfassung der Erfindung

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß einem ersten Aspekt der Erfindung wird eine Bestückmaschine zum Bestücken eines Trägers mit ungehäusten Chips beschrieben. Die Bestückmaschine wird insbesondere verwendet zum Herstellen von elektronischen Bauelementen, welche jeweils zumindest einen Chip aufweisen, der sich in einem Gehäuse befindet, wobei das Gehäuse insbesondere eine ausgehärtete Vergussmasse aufweist. Die beschriebene Bestückmaschine weist auf (a) eine Zuführeinrichtung zum Bereitstellen eines Wafers, der eine Vielzahl von Chips aufweist; (b) eine Träger-Aufnahmevorrichtung zum Aufnehmen des zu bestückenden Trägers; und (c) einen Bestückkopf zum Abholen von Chips von dem bereitgestellten Wafer und zum Platzieren der abgeholten Chips an vordefinierten Bestückpositionen auf dem Träger. Die Träger-Aufnahmevorrichtung weist eine pneumatische Schnittstelle auf, mittels welcher ein Unterdruck an eine Oberfläche des Trägers anlegbar ist. Die Bestückmaschine weist ferner eine Temperiervorrichtung auf, welche thermisch mit der Träger-Aufnahmevorrichtung gekoppelt ist und welche eingerichtet ist, die Träger-Aufnahmevorrichtung zumindest annähernd auf einer konstanten Temperatur zu halten. Hierbei ist die Temperiervorrichtung eingerichtet, die Träger-Aufnahmevorrichtung zu kühlen, so dass diese eine Temperatur annehmen kann, die um zumindest 2 Kelvin niedriger ist als die unmittelbare Umgebungstemperatur der Träger-Aufnahmevorrichtung.

Der beschriebenen Bestückmaschine liegt die Erkenntnis zugrunde, dass ein mit ungehäusten Chips zu bestückender Träger mit extrem hoher Genauigkeit und ohne einen inneren Verzug an einer vorgegebenen Position innerhalb der Bestückmaschine gehalten werden kann, wenn der Träger mittels eines Unterdrucks lösbar an einer geeignet geformten Träger-Aufnahmevorrichtung fixiert wird. Zu diesem Zweck weist die verwendete Träger-Aufnahmevorrichtung die pneumatische Schnittstelle auf, welche an den zu bestückenden Träger anliegt, sofern sich dieser an bzw. auf der Träger-Aufnahmevorrichtung befindet.

Anschaulich ausgedrückt wird der zu bestückende Träger über die pneumatische Schnittstelle an der Träger-Aufnahmevorrichtung angesaugt. Solange die Oberfläche des Trägers, welche an der pneumatischen Schnittstelle anliegt, mit einem ausreichenden Unterdruck beaufschlagt ist, wird auf zuverlässige Weise ein versehentliches Verrutschen des Trägers verhindert. Im Vergleich zu einer lösbaren Fixierung des Trägers mittels bekannter Klemmmechanismen für mit gehäusten elektronischen Bauelementen zu bestückenden Leiterplatten hat die beschriebene pneumatische Fixierung des mit ungehäusten Chips zu bestückenden Trägers den großen Vorteil, dass sie wesentlich temperaturstabiler ist. Dies liegt daran, dass die verschiedenen Komponenten von bekannten Klemmmechanismen unterschiedliche Geometrien haben und damit unterschiedlichen thermischen Ausdehnungen unterworfen sind, so dass sich bei einer Temperaturänderung gleichzeitig auch die Art und Weise der Klemmung verändert. Dadurch verschiebt sich typischerweise die Position von zumindest einem Teil des mit Chips zu bestückenden Trägers innerhalb einer Bestückmaschine.

Abgesehen von der bereits genannten Temperaturstabilität hat die beschriebene pneumatische Fixierung im Vergleich zu einer herkömmlichen Klemmung den Vorteil, dass bei einer geeigneten Ausgestaltung der Träger-Aufnahmevorrichtung der Träger flächig an einer Oberseite der Träger-Aufnahmevorrichtung fixiert werden kann und sogar unerwünschte Wölbungen von Teilbereichen des Trägers nach oben bzw. von der Träger-Aufnahmevorrichtung weg zuverlässig verhindert werden können. In diesem Zusammenhang wird darauf hingewiesen, dass es bei einer typischerweise für zu bestückende Leiterplatten verwendeten seitlichen Klemmung zu einer Durchbiegung der jeweiligen Leiterplatte kommen kann. Ein Durchbiegen des Trägers nach unten könnte somit zwar in bekannter Weise durch geeignete Unterstützungsstifte verhindert werden, ein unerwünschtes Durchbiegen nach oben kann jedoch auf einfache Weise nur durch die hier beschriebene pneumatische Fixierung des mit ungehäusten Chips zu bestückenden Trägers verhindert werden.

Anschaulich ausgedrückt stellt die beschriebene Träger-Aufnahmevorrichtung ein Vakuum-Fixierwerkzeug dar, mit dem der zu bestückende Träger innerhalb der Bestückmaschine so fixiert werden kann, dass die Oberfläche des Trägers exakt in der Höhe einer Ebene liegt, in welcher die Chips am besten und insbesondere mit der größten Bestückgenauigkeit platziert werden können.

Um innerhalb der beschriebenen Bestückmaschine eine positionsgenaue Fixierung des Trägers auch unter schwankenden Umgebungstemperaturen zu gewährleisten, ist es lediglich erforderlich, die Träger-Aufnahmevorrichtung derart auszugestalten, dass deren Geometrie nur eine sehr geringe Temperaturabhängigkeit aufweist. Dies kann beispielsweise durch die Verwendung von geeigneten Materialien wie beispielsweise einer Invar-Legierung geschehen, welche aus ca. 64 % Eisen und 36 % Nickel besteht und welche in bekannter Weise eine sehr geringen Wärmeausdehnungskoeffizienten aufweist.

Es wird darauf hingewiesen, dass die Positionsgenauigkeit, welche notwendig ist, um einen Träger mit ungehäusten Chips zu bestücken, in der Regel wesentlich höher sein muss als die Positionsgenauigkeit, die erforderlich ist, um eine Leiterplatte mit ungehäusten elektronischen Bauelementen zu bestücken. Um eine ausreichend hohe Positionsgenauigkeit zu gewährleisten, leistet die hier beschriebene pneumatische Fixierung des Trägers an der Träger-Aufnahmevorrichtung einen erheblichen Beitrag.

In diesem Zusammenhang wird darauf hingewiesen, dass in diesem Dokument unter dem Begriff "elektronisches Bauelement" insbesondere ein gehäustes elektronisches Bauelement zu verstehen ist, welches (a) einen Chip, (b) ein den Chip umgebendes Gehäuse sowie (c) geeignete elektrische Anschlusskontakte für den Chip aufweist. Ein "elektronisches Bauelement" kann beispielsweise ein für eine Oberflächenmontage vorgesehenes Bauelement sein, welches typischerweise als Surface Mount Device (SMD) Bauelement bezeichnet wird.

Im Gegensatz dazu werden in diesem Dokument unter dem Begriff "Chips" insbesondere ungehäuste Halbleiterplättchen verstanden, welche in bekannter Weise durch ein Vereinzeln von einem prozessierten Halbleiterwafer entstehen.

Gemäß einem Ausführungsbeispiel der Erfindung weist die pneumatische Schnittstelle eine Nut auf, welche mit dem Unterdruck beaufschlagt werden kann, der von einer Unterdruck-Erzeugungseinheit erzeugt wird.

Die Unterdruck-Erzeugungseinheit kann eine Einheit sein, welche in Bezug auf die beschriebene Bestückmaschine eine externe Einheit ist und mit der Träger-Aufnahmevorrichtung lediglich pneumatisch koppelbar ist. Die Unterdruck-Erzeugungseinheit kann jedoch auch der beschriebenen Bestückmaschine zugeordnet sein. Insbesondere in letzterem Fall kann die beschriebene Unterdruck-Erzeugungseinheit beispielsweise aus Synergiegründen auch für die Erzeugung eines Unterdrucks verwendet werden, welcher in bekannter Weise für eine temporäre Aufnahme von Chips an so genannten Saugpipetten des Bestückkopfes verwendet wird.

Die Verwendung einer Nut zur Übertragung des Unterdrucks an die Oberfläche des Trägers hat den Vorteil, dass dieser Unterdruck nicht lediglich punktuell sondern entlang einer Linie angelegt werden kann. Dabei kann die Form und/oder die Länge der Nut an die Größe und/oder an die mechanische Beschaffenheit des mit Chips zu bestückenden Trägers angepasst werden.

Die beschriebene Nut kann auch mehrere Nutabschnitte aufweisen, welche an einem Verzweigungspunkt oder an mehreren Verzweigungspunkten miteinander verbunden sind. Ferner kann zumindest ein Abschnitt der beschriebenen Nut eine umlaufende Nut sein, welche bevorzugt um einen Mittelpunkt der Oberfläche der Träger-Aufnahmevorrichtung bzw. um einen Mittelpunkt des an der Träger-Aufnahmevorrichtung fixierten Trägers umläuft. Somit kann der Unterdruck in weitgehend symmetrischer Weise auf die Oberfläche des zu bestückenden Trägers angelegt werden. Dies wiederum führt dazu, dass der zu bestückende Träger infolge des Unterdrucks nicht oder nur in zu vernachlässigende Weise mechanisch verspannt wird. Auch dies trägt in erheblichen Maße zu einer hohen Bestückgenauigkeit bei.

Erfindungsgemäß weist die Bestückmaschine ferner eine Temperiervorrichtung auf, welche thermisch mit der Träger-Aufnahmevorrichtung gekoppelt ist und welche eingerichtet ist, die Träger-Aufnahmevorrichtung zumindest annähernd auf einer konstanten Temperatur zu halten.

Die Temperiervorrichtung kann die Träger-Aufnahmevorrichtung und damit auch einen an der Träger-Aufnahmevorrichtung pneumatisch fixierten Träger aktiv oder passiv temperaturstabilisieren. Eine passive Temperaturstabilisation kann auf einfache Weise dadurch realisiert werden, dass ein gasförmiges oder flüssiges Wärmeaustauschmedium, welches eine vorbestimmte Temperatur aufweist, durch einen Kanal strömt, welcher in der Träger-Aufnahmevorrichtung ausgebildet ist. Eine aktive Temperaturstabilisation weist zusätzlich eine Temperatur-Rückkopplung von einem Temperatursensor zu einer Steuereinheit der Temperiervorrichtung auf, so dass die Temperatur und/oder der Volumenstrom des Wärmeaustauschmediums stets so eingestellt ist, dass sich zumindest derjenige Teil der Träger-Aufnahmevorrichtung auf einer konstanten und bevorzugt vorgegebenen Temperatur befindet, welcher thermisch mit dem zu bestückenden Träger gekoppelt ist.

Eine Temperaturstabilisierung des zu bestückenden Trägers in Hinblick auf eine präzise Beibehaltung der Position des Trägers innerhalb der Bestückmaschine ist insbesondere für einen "embedded Wafer Level Prozess" Prozess (eWLP) von großer Bedeutung, weil im Gegensatz zu einer Leiterplattenbestückung, welche oft weniger als eine Minute dauert, bei einer Bestückung des Trägers mit Chips aus einem Wafer die Bestückdauern in Anbetracht der typischerweise viel größeren Anzahl an Chips deutlich länger sind. Übliche Bestückdauern des Trägers mit ungehäusten Chips können zwischen einer und mehreren Stunden liegen. Dies hat zur Folge, dass sämtliche (noch so kleine) zeitliche Veränderungen der Bestückmaschine und/oder des zu bestückenden Trägers unmittelbar die Bestückgenauigkeit beeinflussen.

Erfindungsgemäß ist die Temperiervorrichtung eingerichtet, um die Träger-Aufnahmevorrichtung zu kühlen, so dass diese eine Temperatur annehmen kann, die um zumindest 2 Kelvin, insbesondere um zumindest 4 Kelvin und weiter insbesondere um zumindest 7 Kelvin niedriger ist als die unmittelbare Umgebungstemperatur Träger-Aufnahmevorrichtung.

Durch die beschriebene Kühlung der Träger-Aufnahmevorrichtung kann sichergestellt werden, dass eine Abwärme von Komponenten der Bestückmaschine, welche zu einer unerwünschten und kaum vermeidbaren Temperaturerhöhung in einem räumlichen Bereich unter einer Schutzhaube der Bestückmaschine führt, nicht automatisch zur Folge hat, dass sich auch die Temperatur der Träger-Aufnahmevorrichtung und insbesondere die Temperatur des Trägers erhöht. Insbesondere kann durch eine geeignete Einstellung der Temperiervorrichtung erreicht werden, dass der Träger während des Bestückens eine Temperatur annimmt, die zumindest annähernd gleich ist wie eine Umgebungstemperatur der Bestückmaschine. Dies bedeutet in der Praxis, dass der Träger beim Einführen in die Bestückmaschine und beim Herausführen aus der Bestückmaschine keinen oder nur zu vernachlässigenden Temperaturänderungen unterworfen ist. Bei Einführen des Trägers hätte eine Temperaturerhöhung nämlich zur Folge, dass sich die räumlichen Abmessungen des Trägers als Folge einer thermischen Ausdehnung ändern würde und die Bestückgenauigkeit entsprechend reduziert wäre.

Gemäß einem weiteren Ausführungsbeispiel der Erfindung weist die Bestückmaschine ferner ein Chassis und ein Positioniersystem auf. Das Flächen-Positioniersystem wiederum weist auf (a) eine erste Komponente, die in Bezug zu dem Chassis stationär angeordnet ist, (b) eine zweite Komponente, die in Bezug zu der ersten Komponente entlang einer vorgegebenen ersten Richtung verfahrbar ist, und (c) eine dritte Komponente, die in Bezug zu der zweiten Komponente entlang einer vorgegebenen zweiten Richtung verfahrbar ist. Der Bestückkopf ist an der dritten Komponente befestigt. Die erste Richtung ist winklig zu der zweiten Richtung. Dabei ist unter dem Begriff "winklig" jede nicht parallele Ausrichtung der beiden Richtungen zu verstehen.

Durch eine geeignete Ansteuerung von einem ersten Linearantrieb, welcher der ersten Komponente und der zweiten Komponente zugeordnet ist, und einem zweiten Linearantrieb, welcher der zweiten Komponente und der dritten Komponente zugeordnet ist, kann die dritte Komponente und damit der an ihr befestigte Bestückkopf innerhalb eines bestimmen zweidimensionalen Bewegungsbereichs frei verfahren werden. Bei der beschriebenen Bestückmaschine erstreckt sich dieser Bewegungsbereich von einem räumlichen Bereich der Zuführeinrichtung, in welchem die zu bestückenden Chips aufgenommen werden, bis hin zu einem Bestückbereich, in welchem sich der zu bestückende Träger befindet und in dem welchem die Chips aufgesetzt werden.

Die beiden genannten Richtungen, welche bevorzugt senkrecht zueinander orientiert sind, können durch zwei Achsen, beispielsweise eine x-Achse und eine y-Achse, definiert sein. Diese beiden Achsen können ein Koordinatensystem der beschriebenen Bestückmaschine aufspannen.

Die erste Komponente des Positioniersystems kann eine stationäre Führungsschiene aufweisen, welche sich entlang der x-Achse erstreckt. Die bewegliche zweite Komponente kann ein querstehender Trägerarm sein, welcher an der ersten Komponente entlang der x-Achse verschiebbar angeordnet ist und sich entlang der γ-Achse erstreckt. Die dritte Komponente des Positioniersystems kann an dem querstehenden Trägerarm angeordnet und entlang einer Schiene verfahrbar sein, welche sich entlang der Längsrichtung des querstehenden Trägers bzw. entlang der γ-Achse erstreckt.

Gemäß einem weiteren Ausführungsbeispiel der Erfindung weist die Träger-Aufnahmevorrichtung zumindest zwei Markierungen auf, welche optisch erkennbar sind und welche insbesondere außerhalb eines räumlichen Bereiches, der für die Aufnahme des Trägers vorgesehen ist, an der Träger-Aufnahmevorrichtung angebracht sind. Anhand von zumindest einer solchen Markierung kann durch eine geeignete optische Vermessung die Position eines bestückten Chips relativ zu dieser Markierung mit großer Genauigkeit bestimmt werden. Sofern die Position der betreffenden Markierung innerhalb der beschriebenen Bestückmaschine genau bekannt ist, kann somit die tatsächliche Position eines bestückten Chips innerhalb eines Koordinatensystems der Bestückmaschine genau ermittelt werden. Sofern außerdem die Position des zu bestückenden Trägers innerhalb des Koordinatensystems der Bestückmaschine genau bekannt ist, kann dann auch die tatsächliche Position eines bestückten Chips innerhalb eines Koordinatensystems des Trägers mit großer Genauigkeit ermittelt werden.

Falls bei einer derartigen Positionsvermessung ein gewisser räumlicher Versatz zwischen der tatsächlichen Bestückposition und einer vorgegebenen Bestückpositionen ermittelt wird, dann kann ein solcher Versatz bei nachfolgenden Bestückvorgängen durch eine geeignete Ansteuerung der Bewegung des Bestückkopfes zumindest annähernd kompensiert werden.

Die genauen Positionen der optisch erkennbaren Markierungen können vor dem Einbau der Träger-Aufnahmevorrichtung bzw. einer entsprechenden Komponente der Träger-Aufnahmevorrichtung, an welcher Komponente sich die Markierungen befinden, mit einer hochgenauen optischen Messmaschine vermessen werden. Auf diese Weise kann die vorstehend beschriebene optische Vermessung von Bestückpositionen mit besonders hoher Genauigkeit durchgeführt werden.

Die räumliche Anordnung der beiden Markierungen außerhalb des Bereiches, welcher im Betrieb der Bestückmaschine für die Aufnahme des Trägers vorgesehen ist, hat den Vorteil, dass die (Positionen der) Markierungen auch während der Bestückung eines Trägers vermessen werden können. Somit ist es auch während eines Bestückvorgangs, welcher, wie vorstehend beschrieben, beispielsweise 1 bis 2 Stunden dauern kann, möglich, die Bestückpositionen optisch genau zu identifizieren und so eine andauernd hohe Bestückgenauigkeit zu gewährleisten.

Gemäß einem weiteren Ausführungsbeispiel der Erfindung weist die Träger-Aufnahmevorrichtung zumindest zwei weitere Markierungen auf, welche optisch erkennbar sind und welche insbesondere außerhalb eines räumlichen Bereiches an der Träger-Aufnahmevorrichtung angebracht sind, welcher Bereich für die Aufnahme des Trägers vorgesehen ist. Dies bedeutet, dass an der Träger-Aufnahmevorrichtung insgesamt zumindest vier optisch erkennbare Markierungen vorhanden sind. Diese vier Markierungen können zur Verbesserung der Bestückgenauigkeit für einen ersten Messzweck (A) und/oder für einen zweiten Messzweck (B) verwendet werden, wobei jeweils davon ausgegangen wird, dass die vier Markierungen in räumlich fester Weise in dem Koordinatensystem der Bestückmaschine angeordnet sind bzw. das Koordinatensystem der Bestückmaschine sogar definieren.
(A) Messzweck 1: Durch ein Vermessen von tatsächlichen Bestückpositionen von auf den Träger aufgesetzten Chips relativ zu den vier Markierungen ist es möglich, für eine Kompensation von Bestückpositionen durch ein geeignetes Ansteuern der Bewegung des Bestückkopfes ein erweitertes kinematisches Modell zu verwenden, bei dem mit einer bi-lineareren Koordinaten-Transformation nicht nur eindimensionale Verzeichnungen und Winkelverzeichnungen sondern z. B. auch Trapezverzeichnungen abgebildet werden können. Dies bedeutet, dass auch ein nichtlineares Positionierverhalten von einem Positioniersystem, welches den Bestückkopf trägt, anhand der vier Markierungen approximiert werden und einem Mapping-Feld überlagert werden kann, welches in bekannter Weise dazu verwendet wird, eine Bewegung des Bestückkopfes individuell für eine Vielzahl an möglichen Bestückpositionen positionsgenau zu steuern.
(B) Messzweck 2: Auf oder in unmittelbarer Nähe zu den vier Markierungen kann in einem Kalibrierbetrieb der Bestückmaschine von dem Bestückkopf jeweils ein spezieller Kalibrierchip aufgesetzt werden. Durch eine geeignete optische Positionsvermessung kann ein möglicher Versatz der Bestückpositionen im Bereich der vier Markierungen hochgenau ermittelt werden. Die dadurch gewonnenen Informationen können einen so genannten Mapping-Feld überlagert werden. Ein solches Mapping-Feld kann dann in bekannter Weise dazu verwendet werden, die Positionierung des Bestückkopfes mittels des vorstehend genannten Positioniersystems so vorzunehmen, dass ein gegebenenfalls vorhandener Verzug des Positioniersystem ortsabhängig, d.h. für jede Bestückposition individuell, kompensiert werden kann.

Gemäß einem weiteren Ausführungsbeispiel der Erfindung (a) haben die beiden Markierungen relativ zueinander einen räumlichen Versatz entlang der ersten Richtung, (b) haben die beiden weiteren Markierungen relativ zueinander einen räumlichen Versatz entlang der ersten Richtung, und (c) hat jede der beiden Markierungen relativ zu jeder der beiden weiteren Markierungen einen räumlichen Versatz entlang der zweiten Richtung.

In einer besonders einfachen Realisierung dieser Ausführungsform haben die beiden Markierungen relativ zueinander ausschließlich einen räumlichen Versatz entlang der ersten Richtung (und keinen Versatz entlang der zweiten Richtung). Gleiches gilt für die beiden weiteren Markierungen. Ferner gibt es zwei Markierungspaare, die jeweils eine Markierung und eine weitere Markierung umfassen, wobei die Markierungen eines Paares ausschließlich einen räumlichen Versatz entlang der zweiten Richtung (und keinen Versatz entlang der ersten Richtung) haben. Anschaulich ausgedrückt sind bei dieser Realisierung alle Markierungen auf einem rechtwinkligen zweidimensionalen Raster an der Träger-Aufnahmevorrichtung platziert.

Durch eine optische Vermessung von jeweils einem Paar von Markierungen, welche einen Versatz entlang der ersten Richtung haben, mittels einer Kamera, welche entlang der zweiten Richtung verschiebbar an der dritten Komponente angebracht ist, kann ein ggf. vorhandener oder im Verlauf einer Bestückung entstandener räumlicher Verzug der (stationären) ersten Komponente des Positioniersystems erkannt werden. Ein solcher räumlicher Verzug kann insbesondere dadurch entstehen, dass sich im Verlauf der Bestückung eines Trägers die Temperatur von zumindest einem Teil der ersten Komponente ändert.

In entsprechender Weise kann durch eine optische Vermessung von jeweils einem Paar von Markierungen, welche einen Versatz entlang der zweiten Richtung haben, mittels der genannten Kamera ein ggf. vorhandener oder im Verlauf einer Bestückung entstandener räumlicher Verzug der (verfahrbaren) zweiten Komponente des Positioniersystems erkannt werden. Auch dieser Verzug kann durch unerwünschte Temperaturschwankungen in Verbindung mit thermischen Ausdehnungen entstehen.

Anschaulich ausgedrückt verzerrt sich bei einem Verzug der (stationären) ersten Komponente und/oder bei einem Verzug der (verfahrbaren) zweiten Komponente das Koordinatensystem des Positioniersystems. Durch eine optische Positionsvermessung der entsprechenden als stationär angenommenen Markierungen kann dieser Verzug bestimmt werden und bei der weiteren Bestückung des Trägers durch eine geeignete Ansteuerung des Positioniersystems kompensiert werden. Insbesondere bei der Verwendung eines bilinearen Modells zur Bestimmung der Verzerrung kann dadurch kann eine extrem hohe und zeitlich stabile Bestückgenauigkeit erzielt werden.

Es wird darauf hingewiesen, dass es durch eine optische Vermessung sowohl der beiden Markierungen als auch der beiden weiteren Markierungen möglich ist, folgende Ursachen einer Verzerrung des Koordinatensystems des Positioniersystems eindeutig zu identifizieren: (a) Stauchung oder Ausdehnung der ersten Komponente, (b) Krümmung bzw. Aufwölbung der ersten Komponente, (c) Stauchung oder Ausdehnung der zweiten Komponente, (d) Krümmung der zweiten Komponente. Dies ermöglicht eine besonders genaue Bestimmung der Verzerrung des Koordinatensystem auch für Positionen, welche sich zwischen des verschiedenen Markierungen befinden.

Gemäß einem weiteren Ausführungsbeispiel der Erfindung weist die Träger-Aufnahmevorrichtung ferner zumindest eine Zwischenmarkierung auf, welche sich entlang der ersten Richtung zwischen den beiden Markierungen befindet. Alternativ oder in Kombination weist die Träger-Aufnahmevorrichtung ferner zumindest eine weitere Zwischenmarkierung auf, welche sich entlang der ersten Richtung zwischen den beiden weiteren Markierungen befindet. Dies hat den Vorteil, dass die Genauigkeit der Bestimmung der Verzerrung des Koordinatensystems des Positioniersystems insbesondere in Bezug auf mögliche räumliche Veränderungen der (stationären) ersten Komponente weiter verbessert werden kann. Dabei ist diese Verbesserung umso größer, je höher die Anzahl der Zwischenmarkierungen bzw. der weiteren Zwischenmarkierungen ist.

Gemäß einem weiteren Ausführungsbeispiel der Erfindung ist an der Träger-Aufnahmevorrichtung zumindest eine Zusatzmarkierung angebracht, welche sich entlang der zweiten Richtung zwischen einer Markierung und einer weiteren Markierung befindet. Alternativ oder in Kombination ist an der Träger-Aufnahmevorrichtung ferner zumindest eine weitere Zusatzmarkierung angebracht, welche sich entlang der zweiten Richtung zwischen einer Markierung und einer weiteren Markierung befindet. Dies hat den Vorteil, dass die Genauigkeit der Bestimmung der Verzerrung des Koordinatensystems des Positioniersystems insbesondere in Bezug auf mögliche räumliche Veränderungen der (verfahrbaren) zweiten Komponente weiter verbessert werden kann. Auch hier ist diese Verbesserung umso größer, je höher die Anzahl der Zusatzmarkierungen bzw. der weiteren Zusatzmarkierungen ist.

Gemäß einem weiteren Ausführungsbeispiel der Erfindung weist die Bestückmaschine ferner auf eine Transportvorrichtung zum Zuführen von zu bestückenden Trägern zu der Träger-Aufnahmevorrichtung und zum Abführen von zumindest teilweise mit ungehäusten Chips bestückten Trägern von der Träger-Aufnahmevorrichtung. Die Transportvorrichtung weist zwei Transportspuren auf, welche sich entlang der zweiten Richtung erstrecken und entlang der ersten Richtung voneinander beabstandet sind und welche ausgebildet sind, einen Träger an zwei Seiten zu halten. Ferner ist die zumindest eine Zusatzmarkierung und/oder die zumindest eine weitere Zusatzmarkierung außerhalb der beiden Transportspuren angeordnet.

Durch die Verwendung von weiteren Zusatzmarkierungen kann die vorstehend beschriebene optische Bestimmung einer Verzerrung des Koordinatensystems des Positioniersystems insbesondere in Bezug auf mögliche räumliche Veränderungen der verfahrbaren und sich entlang der ersten Richtung erstreckenden zweiten Komponente weiter verbessert werden.

"Außerhalb" kann in diesem Zusammenhang insbesondere bedeuten, dass sich die jeweilige Zusatzmarkierung außerhalb des Bereiches befindet, welcher zwischen den beiden Transportspuren liegt und durch die beiden Transportspuren entlang der ersten Richtung begrenzt ist. Da auch die jeweilige Zusatzmarkierung an der Träger-Aufnahmevorrichtung angebracht ist, bedeutet dies, dass sich auch die Träger-Aufnahmevorrichtung bis außerhalb der beiden Transportspuren erstreckt.

Die Träger-Aufnahmevorrichtung kann mehrstückig ausgebildet sein. Bevorzugt ist jedoch zumindest die Oberfläche der Träger-Aufnahmevorrichtung die Oberfläche einer einstückigen Komponente der Träger-Aufnahmevorrichtung.

Die räumliche Anordnung der zumindest einen Zusatzmarkierung und/oder der zumindest einen weiteren Zusatzmarkierung außerhalb der beiden Transportspuren hat den Vorteil, dass weder der Transport noch die Aufnahme des Trägers durch die jeweilige(n) Zusatzmarkierung(en) behindert wird. Eine optische Vermessung der Zusatzmarkierung und/oder der weiteren Zusatzmarkierung ist auch während eines Bestückvorgangs möglich (wenn sich der zu bestückende Träger auf der Träger-Aufnahmevorrichtung befindet).

Gemäß einem weiteren Ausführungsbeispiel der Erfindung sind die Transportspuren mittels jeweils eines Transportriemens realisiert. Auf diesen kann ein Träger während seines Transports aufliegen. In der Träger-Aufnahmevorrichtung sind zwei Transportnuten ausgebildet, welche entlang der zweiten Richtung verlaufen und räumlich derart ausgebildet sind, dass in jeder Transportnut jeweils ein Transportriemen versenkbar ist. Dadurch wird auf vorteilhafte Weise eine pneumatische Fixierung des Trägers auf der Träger-Aufnahmevorrichtung nicht durch die Transportriemen behindert.

Ein temporäres Absenken der Transportriemen kann beispielsweise dadurch realisiert werden, dass innerhalb der Transportnut jeweils vertikal, d.h. senkrecht sowohl zur ersten Richtung als auch zur zweiten Richtung, verschiebbare Rollen vorgesehen sind, auf welchen der jeweilige Transportriemen aufliegt. Eine solche Verschiebbarkeit kann beispielsweise mittels zweier sägezahnförmiger Bleche realisiert werden, welche bei einer Verschiebung entlang der zweiten Richtung dafür sorgen, dass die Drehachsen der jeweiligen Rollen vertikal verschoben werden.

Gemäß einem weiteren Ausführungsbeispiel der Erfindung weist die Bestückmaschine ferner ein Referenzelement auf, welches an der Träger-Aufnahmevorrichtung befestigt ist. Die zumindest eine Zusatzmarkierung und/oder die zumindest eine weitere Zusatzmarkierung sind an dem Referenzelement angebracht.

Das Referenzelement kann ein sog. Maßstab sein, welcher aus einem Material mit einer sehr geringen thermischen Ausdehnung gefertigt ist. Die zumindest eine Zusatzmarkierung und/oder die zumindest eine weitere Zusatzmarkierung können mit einer extrem hohen Positionsgenauigkeit an dem Referenzelement angebracht sein oder die Position der Markierungen kann durch eine hochgenaue Vermessung bekannt sein. Dadurch wird die Genauigkeit der Vermessung einer Verzerrung des Positioniersystems weiter verbessert.

Das Referenzelement kann beispielsweise ein sog. Glasmaßstab sein.

Gemäß einem weiteren Ausführungsbeispiel der Erfindung weist die Bestückmaschine ferner eine Kamera auf, welche derart positioniert oder positionierbar ist, dass zumindest eine der Markierungen und auf den Träger bestückte Chips gemeinsam in einem Bild von der Kamera aufgenommen werden können.

Das Bereitstellen einer Kamera in der Bestückmaschine, welche Kamera im Prinzip ständig zur Verfügung steht, um die Markierungen und auf den Träger bestückte Chips zu erfassen, kann die Genauigkeit der beschriebenen Bestückmaschine während das Betriebs der Bestückmaschine ständig oder zumindest in regelmäßigen Abständen überprüft werden. Falls eine solche Überprüfung ergibt, dass es bei der Bestückung von Chips zu einem räumlichen Versatz kommt, dann können diese durch die vorstehend beschriebenen Maßnahmen, das heißt insbesondere durch eine geeignete Ansteuerung der Antriebe des oben genannten Positioniersystems, kompensiert werden.

Gemäß einem weiteren Ausführungsbeispiel der Erfindung ist die Kamera relativ zu dem Bestückkopf in einer räumlich festen Position angeordnet. Dies kann insbesondere bedeuten, dass die Kamera an der dritten Komponente des vorstehend genannten Positioniersystems bzw. an dem Bestücckopf angebracht ist. Die Kamera kann dabei direkt oder indirekt an der dritten Komponente bzw. an dem Bestückkopf befestigt sein. Dadurch kann auf apparativ besonders einfache Weise die Kamera als eine innerhalb der Bestückmaschine bewegliche Kamera realisiert werden.

Eine innerhalb der Bestückmaschine bewegliche Kamera kann nicht nur die vorstehend genannten Markierungen sondern auch optische Strukturen an dem mit Chips zu bestückenden Träger erkennen, so dass die Position des zu bestückenden Trägers innerhalb des Koordinatensystems der Bestückmaschine zumindest grob bekannt ist. Eine solche Vermessung der Position des Trägers ist deshalb erforderlich, weil der zu bestückende Träger typischerweise mittels eines Transportsystems in dem Bestückbereich der Bestückmaschine eingebracht bzw. zu der Träger-Aufnahmevorrichtung transferiert wird. Durch eine Positionsvermessung der an dem Träger angebrachten bzw. ausgebildeten optischen Strukturen kann das Transportsystem dann auf eine geeignete Weise angesteuert werden, so dass der zu bestückende Träger möglichst genau zu der Träger-Aufnahmevorrichtung transferiert wird.

Gemäß einem weiteren Ausführungsbeispiel der Erfindung weist der Bestückkopf eine Mehrzahl von Haltevorrichtungen zum temporären Aufnehmen von jeweils einem Chip auf. Die Verwendung eines sogenannten Mehrfach-Bestückkopfes hat den Vorteil, dass von dem Bestückkopf aus der Zuführeinrichtung innerhalb einer sehr kurzen Zeit eine Mehrzahl von Chips aufgenommen, diese Mehrzahl von Chips dann gemeinsam hin zu dem Bestückbereich transportiert und dort an vorgegebenen Bestückpositionen auf dem Träger platziert werden kann. Auf diese Weise wird die Bestückleistung der beschriebenen Bestückmaschine im Vergleich zu einer Bestückmaschine mit lediglich einem Einfach-Bestückkopf erheblich verbessert.

Gemäß einem weiteren Ausführungsbeispiel der Erfindung weist die Bestückmaschine ferner auf (a) eine weitere Zuführeinrichtung zum Bereitstellen eines weiteren Wafers, der ebenfalls eine Vielzahl von Chips aufweist; und (b) einen weiteren Bestückkopf zum Abholen von Chips von dem bereitgestellten weiteren Wafer und zum Platzieren der abgeholten Chips an vordefinierten Bestückpositionen auf dem Träger. Dies hat den Vorteil, dass die Bestückmaschine in einem Betriebsmodus betrieben werden kann, in dem die beiden Bestückköpfe jeweils abwechselnd Chips von ihrer jeweils zugeordneten Zuführeinrichtung aufnehmen und auf den zu bestückenden Träger aufsetzen. Anschaulich ausgedrückt: Innerhalb eines ersten Zeitfensters werden von den (ersten) Bestückkopf Chips von der (ersten) Zuführeinrichtung abgeholt und von dem (zweiten) weiteren Bestückkopf werden bereits aufgenommene Chips auf den Träger aufgesetzt. Innerhalb eines nachfolgenden zweiten Zeitfensters werden von den (zweiten) weiteren Bestückkopf Chips von der (zweiten) Zuführeinrichtung abgeholt und von dem (ersten) Bestückkopf zuvor von der (ersten) Zuführeinrichtung aufgenommene Chips auf den Träger aufgesetzt. Durch einen solchen wechselseitigen Betrieb der beiden Bestückkopfes kann die Bestückleistung um zumindest annähernd einen Faktor 2 erhöht werden.

Gemäß einem weiteren Aspekt der Erfindung wird ein Verfahren zum Bestücken eines Trägers mit ungehäusten Chips mit einer Bestückmaschine beschrieben, wobei die Bestückmaschine insbesondere eine Bestückmaschine des vorstehend beschriebenen Typs ist. Das beschriebene Verfahren weist folgende Schritte auf: (a) ein Bereitstellen eines Wafers, der eine Vielzahl von Chips aufweist, mittels einer Zuführeinrichtung; (b) ein Aufnehmen des zu bestückenden Trägers mittels einer Träger-Aufnahmevorrichtung; (c) ein Fixieren des zu bestückenden Trägers an der Träger-Aufnahmevorrichtung mittels eines Unterdrucks, welcher über eine pneumatische Schnittstelle der Träger-Aufnahmevorrichtung an eine Oberfläche des Trägers angelegt wird; (d) ein Abholen von bereitgestellten Chips von der Zuführeinrichtung mittels eines Bestückkopfes; (e) ein Transportieren der abgeholten Chips hin zu einem Bestückbereich; und (f) ein Aufsetzen der transportierten Chips an vorbestimmten Bestückpositionen auf dem Träger.

Auch dem beschriebenen Verfahren liegt die Erkenntnis zugrunde, dass sich ein Unterdruck in besonderem Maße dazu eignet, einen mit ungehäusten Chips zu bestückenden Träger mit extrem hoher Genauigkeit an einer vorgegebenen Position innerhalb der Bestückmaschine zu halten.

Gemäß einem weiteren Ausführungsbeispiel der Erfindung weist der Träger eine Platte und eine Klebefolie auf, welche an einer flächigen Oberseite auf der Platte aufgebracht ist.

Die beschriebene Klebefolie ist insbesondere eine beidseitige Klebefolie, so dass nicht nur die Klebefolie an der Trägerplatte sondern auch die aufgesetzten Chips auf der Klebefolie anhaften. Ein gleichmäßiges Aufbringen der Klebefolie auf die Trägerplatte kann insbesondere mittels Laminierens realisiert werden.

Bevorzugt ist die Klebefolie eine so genannte Thermo-Ablöseschicht, welche sich dadurch auszeichnet, dass die Klebrigkeit der Klebefolie bei einer Wärmebehandlung nachlässt oder sogar ganz verschwindet. Somit können bei der Herstellung von gehäusten Bauelementen in einem späteren Schritt, d.h. nach einem gemeinsamen Vergießen der bestückten Chips mit einer aushärtbaren Vergussmasse, die vergossenen Bauelemente auf einfache Weise von der Klebefolie entfernt werden.

Gemäß einem weiteren Ausführungsbeispiel der Erfindung weist das Verfahren ferner auf (a) ein Zuführen des Trägers zu der Träger-Aufnahmevorrichtung mittels einer Transportvorrichtung; (b) ein Erfassen der Positionen von zwei optischen Strukturen, welche sich an dem zugeführten Träger befinden; (c) ein Bestimmen der Position des zugeführten Trägers basierend auf den erfassten Positionen; und (e) ein Ermitteln der Koordinaten der vorbestimmten Bestückpositionen in einem Koordinatensystem der Bestückmaschine basierend auf der bestimmten Position des zugeführten Trägers. Die vorbestimmten Bestückpositionen auf dem Träger hängen von den ermittelten Koordinaten ab.

Die beiden optischen Strukturen des Trägers können zunächst dazu verwendet werden, mittels einer geeigneten Bildverarbeitung die Position des zugeführten Trägers in dem Koordinatensystem der Bestückmaschine zumindest annähernd zu bestimmen. Dadurch kann auf einfache Weise sichergestellt werden, dass der zu bestückende Träger an der Träger-Aufnahmevorrichtung in einer geeigneten räumlichen Position mittels Unterdrucks fixiert wird.

In einem einfachen Ausführungsbeispiel können die beiden optischen Strukturen einfach zwei Löcher sein, die an einem Rand, insbesondere an einander gegenüberliegenden Positionen, an dem Träger angebracht bzw. ausgebildet sind. Das Verwenden von einfachen Löchern als optische Strukturen hat den Vorteil, dass diese Löcher auch für eine mechanische Handhabung des Trägers beispielsweise mittels Zentrierstiften verwendet werden können.

Es wird darauf hingewiesen, dass der zu bestückende Träger selbstverständlich auch mehr als zwei optisch erkennbare Strukturen aufweisen kann. Dadurch kann die Genauigkeit der Positionierungsbestimmung des Trägers in dem Koordinatensystem der Bestückmaschine weiter verbessert werden.

Die beiden optischen Strukturen des Trägers können ferner dazu verwendet werden, nach einem pneumatischen Fixieren des Trägers an der Träger-Aufnahmevorrichtung den Träger als einen steifen Festkörper (d.h. ohne einen Verzug) zu modellieren, so dass jede mögliche Bestückposition auf dem Träger in Bezug zu den beiden optischen Strukturen genau definiert ist.

Gemäß einem weiteren Ausführungsbeispiel der Erfindung weist das Verfahren ferner ein Erfassen der Positionen von mindestens zwei Markierungen auf, welche sich an der Träger-Aufnahmevorrichtung befinden. Die vorbestimmten Bestückpositionen auf dem Träger hängen ferner von den Positionen der mindestens zwei Markierungen ab.

Die Markierungen an der Trägeraufnahmevorrichtung können für eine hochgenaue relative Positionsmessung von bestückten Chips verwendet werden. Dadurch kann die Bestückgenauigkeit der Bestückmaschine während ihres Betriebs auf einfache Weise überwacht und ein gegebenenfalls auftretender räumlicher Versatz bei den Bestückpositionen durch eine geeignete Ansteuerung eines den Bestückkopf tragenden Flächen Positioniersystems kompensiert werden.

Das Erfassen der beiden Markierungen erfolgt bevorzugt mittels einer Kamera und einer der Kamera nachgeschalteten Datenverarbeitungseinheit, welche eine Bildverarbeitung bzw. Bildauswertung ausführt. Um die Genauigkeit des hier beschriebenen Verfahrens zu verbessern, können auch noch weitere Markierungen berücksichtigt werden, welche sich ebenfalls an der Träger-Aufnahmevorrichtung befinden.

Gemäß einem weiteren Ausführungsbeispiel der Erfindung werden die Positionen der beiden Markierungen an der Träger-Aufnahmevorrichtung während des Bestückens eines Trägers in vorgegebenen zeitlichen Abständen wiederholt erfasst und die Koordinaten der vorbestimmten Bestückpositionen werden basierend auf den erfassten Positionen korrigiert.

Anschaulich ausgedrückt werden die zumindest zwei Markierungen während des Betriebs der Bestückmaschine zyklisch vermessen. Damit können über die Kompensation von thermischen Effekten und eine geeignete Approximation eines nichtlinearen Verhaltens des Positioniersystems hinaus auch räumliche Veränderungen erkannt und gegebenenfalls bei der Bestückung kompensiert werden, welche räumlichen Veränderungen über längere Zeiträume auftreten und deren Ursachen gegebenenfalls nicht bekannt sind.

Es wird darauf hingewiesen, dass bei der positionsgenauen Fixierung des Trägers auf der Träger-Aufnahmevorrichtung abgesehen von der zyklischen Vermessung der Markierungen an der Träger-Aufnahmevorrichtung ein erneutes Vermessen des Trägers anhand seiner beiden optisch erkennbaren Strukturen nicht mehr notwendig ist, um trotzdem eine hochgenaue Bestückung zu gewährleisten.

Gemäß einem weiteren Ausführungsbeispiel der Erfindung weist das Verfahren ferner auf (a) ein Vermessen der Position von einer auf den Träger bestückten Struktur; (b) ein erneutes Vermessen der Position von der Struktur zu einem späteren Zeitpunkt während des Bestückens des Trägers mit ungehäusten Chips; und (c) ein Bestimmen einer relativen Positionsverschiebung der Struktur zwischen dem Vermessen und dem erneuten Vermessen. Dabei hängen die vorbestimmten Bestückpositionen auf dem Träger ferner von der Positionsverschiebung der Struktur ab.

Anschaulich ausgedrückt wird eine sich mit der Zeit einstellende zeitabhängige Positionsveränderung bzw. Positionsverschiebung der Struktur beobachtet und daraus Rückschlüsse auf eine zeitabhängige Verzerrung des Positioniersystem gezogen, welche insbesondere durch die vorstehend beschriebenen Auswirkungen von Temperaturänderungen auf die Komponenten des Positioniersystems verursacht werden. Dadurch kann eine zeitabhängige Verzerrung des Positioniersystems alternativ oder in Kombination zu der Verwendung der vorstehend genannten Markierungen, weiteren Markierungen, Zwischenmarkierungen, weiteren Zwischenmarkierungen, Zusatzmarkierungen und/oder weiteren Zusatzmarkierungen auch basierend auf Stützstellen ermittelt werden, welche sich innerhalb des Bestückungsfeldes der Bestückmaschine befinden. Auch hier gilt, dass die Genauigkeit der Verzerrungsbestimmung mit der Anzahl der Strukturen zunimmt, welche für die Bestimmung berücksichtigt werden.

Gemäß einem weiteren Ausführungsbeispiel der Erfindung ist die Struktur eine optisch erkennbare Struktur von einem bestückten Kalibrierbaustein.

Die Verwendung von speziellen Kalibrierbausteinen hat den Vorteil, dass die Struktur eine Markierung oder mehrere Markierungen sein kann, welche optisch einfach und zuverlässig erkannt werden können und/oder welche mit einer extrem hohen räumlichen Genauigkeit an dem jeweiligen Kalibrierbaustein(en) angebracht sein können.

Die Kalibrierbausteine können beispielsweise Glasbausteine sein, welche mit einer extrem hohen Genauigkeit hergestellt werden können. Außerdem können die Glasbausteine aus einem speziellen Glas bestehen, welches eine sehr geringe thermische Ausdehnung aufweist, so dass die Genauigkeit der vorstehend beschriebenen Vermessung einer Verzerrung des Positioniersystems besonders hoch sein kann.

Gemäß einem weiteren Ausführungsbeispiel der Erfindung ist die Struktur eine optisch erkennbare Struktur von einem bestückten ungehäusten Chip. Dies hat den Vorteil, dass eine Bestückung mit speziellen Kalibrierbausteinen nicht erforderlich ist. Die optisch erkennbare Struktur kann beispielsweise zumindest eine Kannte oder eine Ecke des bestückten ungehäusten Chips sein.

Die Struktur kann beispielsweise eine Kante des ungehäusten Chips sein. Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Vorrichtungsansprüchen und andere Ausführungsformen der Erfindung mit Verfahrensansprüchen beschrieben.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.

### Kurze Beschreibung der Zeichnung

Figur 1 zeigt ein Bestücksystem, welches zwei Bestückmaschinen gemäß einem Ausführungsbeispiel der Erfindung aufweist, wobei jede Bestückmaschine zwei Wafer-Zuführvorrichtungen und zwei Bestückköpfe aufweist.
Figur 2 zeigt eine vergrößerte Darstellung von einem Teil des Bestücksystems gemäß Figur 1.
Figur 3 zeigt einen Teil einer Bestückmaschine mit einer Träger-Aufnahmevorrichtung, welche sich seitlich über ein Transportsystem hinaus erstreckt und an welcher eine Mehrzahl von Zusatzmarkierungen angebracht ist, die sich außerhalb des Transportsystems befinden.

### Detaillierte Beschreibung

Es wird darauf hingewiesen, dass in der folgenden detaillierten Beschreibung Merkmale bzw. Komponenten von unterschiedlichen Ausführungsformen, die mit den entsprechenden Merkmalen bzw. Komponenten von einer anderen Ausführungsform nach gleich oder zumindest funktionsgleich sind, mit den gleichen Bezugszeichen oder mit einem Bezugszeichen versehen sind, welches sich von dem Bezugszeichen der gleichen oder zumindest funktionsgleichen Merkmale bzw. Komponenten lediglich in der ersten Ziffer unterscheidet. Zur Vermeidung von unnötigen Wiederholungen werden bereits anhand einer vorher beschriebenen Ausführungsform erläuterte Merkmale bzw. Komponenten an späterer Stelle nicht mehr im Detail erläutert.

Ferner wird darauf hingewiesen, dass die nachfolgend beschriebene Ausführungsform lediglich eine beschränkte Auswahl an möglichen Ausführungsvarianten der Erfindung darstellt. Außerdem wird darauf hingewiesen, dass ggf. verwendete raumbezogene Begriffe, wie beispielsweise "vorne" und "hinten", "oben" und "unten", "links" und "rechts", etc. verwendet werden, um die Beziehung eines Elements zu einem anderen Element oder zu anderen Elementen zu beschreiben, wie in den Figuren veranschaulicht. Demnach können die raumbezogenen Begriffe für Ausrichtungen gelten, welche sich von den Ausrichtungen unterscheiden, die in den Figuren dargestellt sind. Es versteht sich jedoch von selbst, dass sich alle solchen raumbezogenen Begriffe der Einfachheit der Beschreibung halber auf die in den Zeichnungen dargestellten Ausrichtungen beziehen und nicht unbedingt einschränkend sind, da die jeweils dargestellte Vorrichtung, Komponente etc., wenn sie in Verwendung ist, Ausrichtungen annehmen kann, die von den in der Zeichnung dargestellten Ausrichtungen verschieden sein können.

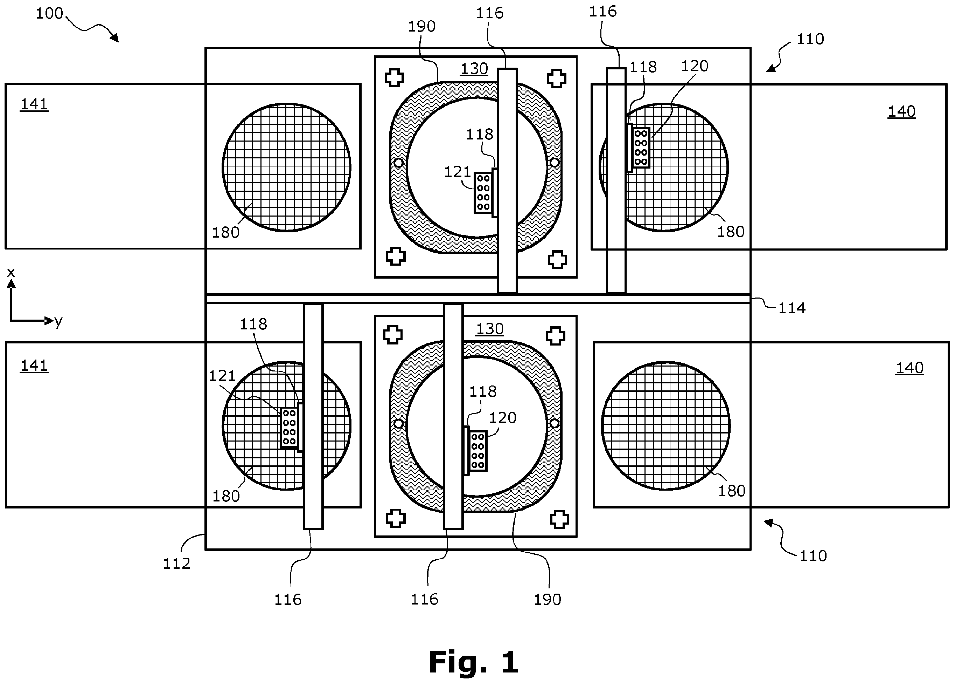

Figur 1 zeigt ein Bestücksystem 100, welches zwei Bestückmaschinen 110 aufweist, die zum Zwecke der Erhöhung der Bestückleistung baulich zusammengefasst worden sind. In diesem Zusammenhang ist unter dem Begriff der "Bestückleistung" die Anzahl an Chips zu verstehen, die innerhalb einer vorgegebene Zeiteinheit, beispielsweise 1 Stunde, von einem Bestückkopf 120 abgeholt und auf einen Träger 190 aufgesetzt werden können.

Es wird darauf hingewiesen, dass die beiden Bestückmaschinen 110 auch jeweils als ein Bearbeitungsbereich des gesamten Bestücksystems 100 angesehen werden können.

Jede der beiden Bestückmaschinen 110 weist ein Chassis 112 auf, die, wie aus Figur 1 ersichtlich, aneinander angrenzend und in nicht dargestellter Weise miteinander verbunden sind. An der Schnittstelle zwischen den beiden Chassis 112 befindet sich eine stationäre Trägerschiene 114, welche eine erste stationäre Komponente von insgesamt vier Flächen-Positioniersystemen aufweist, mittels welchen jeweils ein Bestückkopf 120, 121 in einer zu der Zeichenebene parallelen Ebene verfahren werden kann. Auf der in Figur 1 oberen Seite der Trägerschiene 114 befinden sich zwei Flächen-Positioniersysteme, welche jeweils einen querstehenden Trägerarm 116 und eine verfahrbare Trägerplatte 118 aufweisen. Gleiches gilt für die beiden Flächen-Positioniersysteme, welche in Figur 1 unterhalb der Trägerschiene 114 dargestellt sind.

Wie aus Figur 1 ersichtlich, erstreckt sich die stationäre Trägerschiene 114 entlang einer γ-Richtung. Die querstehenden Trägerarme 116, welche sich entlang einer x-Richtung erstrecken, sind jeweils entlang der stationären Trägerschiene 114 in γ-Richtung verfahrbar. An jedem querstehenden Trägerarm 116 ist eine verfahrbare Trägerplatte 118 angebracht, welche entlang des jeweiligen querstehenden Trägerarms 116 in x-Richtung verfahrbar ist. Die beiden Bestückköpfe 120 und die beiden weiteren Bestückköpfe 121 sind jeweils an einer der verfahrbaren Trägerplatten 118 angebracht.

Jede der beiden Bestückmaschine 110 weist ferner zwei Wafer-Zuführvorrichtungen auf, eine Wafer-Zuführvorrichtung 140 und eine weitere Wafer-Zuführvorrichtung 141. Mit jeder der beiden Wafer-Zuführvorrichtungen 140 kann aus einem in Figur 1 nicht dargestellten Wafer-Speicher ein Wafer 180 in einen Bereitstellungsbereich gebracht werden, von dem einzelne Chips unter Verwendung des jeweiligen Bestücckopfes 120, 121 abgeholt werden können. Bevorzugt sind die Bestückköpfe 120, 121 sogenannte Mehrfach-Bestückköpfe, welche jeweils mehrere in Figur 1 als kleine Kreise dargestellte Saugpipetten aufweisen. Von einer Saugpipette kann jeweils ein Chip temporär aufgenommen werden. Gemäß dem hier dargestellten Ausführungsbeispiel können die Saugpipetten individuell entlang einer z-Richtung verfahren werden, welche senkrecht zu der Zeichenebene und damit sowohl senkrecht zu der γ-Richtung als auch senkrecht zu der x-Richtung orientiert ist.

Die von dem jeweiligen Bestückkopf 120, 121 aufgenommenen Chips werden dann durch eine geeignete Ansteuerung des betreffenden Flächen-Positioniersystems in einen Bestückbereich transferiert, in welchem sie auf einen zu bestückenden Träger 190 an vordefinierten Positionen aufgesetzt werden.

Wie bereits vorstehend erläutert, kann die mit zwei Bestückköpfen 120, 121 und zwei Zuführvorrichtungen 140, 141 versehene Bestückmaschine 110 auf vorteilhafte Weise in einem Betriebsmodus betrieben werden, in dem die beiden Bestückköpfe 120, 121 jeweils abwechselnd Chips von ihrer jeweils zugeordneten Zuführeinrichtung 140, 141 aufnehmen und auf den zu bestückenden Träger 190 aufsetzen. Dadurch kann die Bestückleistung erheblich erhöht werden.

Jede der beiden Bestückmaschinen 110 weist ferner eine Träger-Aufnahmevorrichtung 130 auf, mittels welcher der zu bestückende Träger 190 während des Bestückvorgangs in einer festen räumlichen Position in einem Koordinatensystem der jeweiligen Bestückmaschine 110 gehalten bzw. fixiert wird. In diesem Zusammenhang wird darauf hingewiesen, dass im Gegensatz zu einer Bestückung von Leiterplatten mit gehäusten elektronischen Bauelementen eine Bestückung des Trägers 190 mit ungehäusten Chips deutlich länger dauert, da der Träger 190 im Vergleich zu der Anzahl von auf einer Leiterplatte zu bestückenden gehäusten elektronischen Bauelementen typischerweise mit einer wesentlich höheren Anzahl an Chips bestückt wird. Aus diesem Grund werden an die Genauigkeit der Positionierung des zu bestückenden Trägers 190 extrem hohe Anforderungen gestellt. In diesem Zusammenhang muss gewährleistet werden, dass sich weder die Position des gesamten Trägers 190 noch die Positionen einzelner Teilbereiche des Trägers 190 während der gesamten Bestückdauer von beispielsweise 2 Stunden ändern. Gleiches gilt für die Verfahrwege des betreffenden Flächen-Positioniersystems. In Anbetracht von nie zu vermeidenden Wärmeeinträgen, die beispielsweise von Motoren des jeweiligen Flächen-Positioniersystems 114, 116, 118 verursacht werden, muss daher eine extrem hohe Temperaturstabilität insbesondere der gesamten Träger-Aufnahmevorrichtung 130 gewährleistet werden.

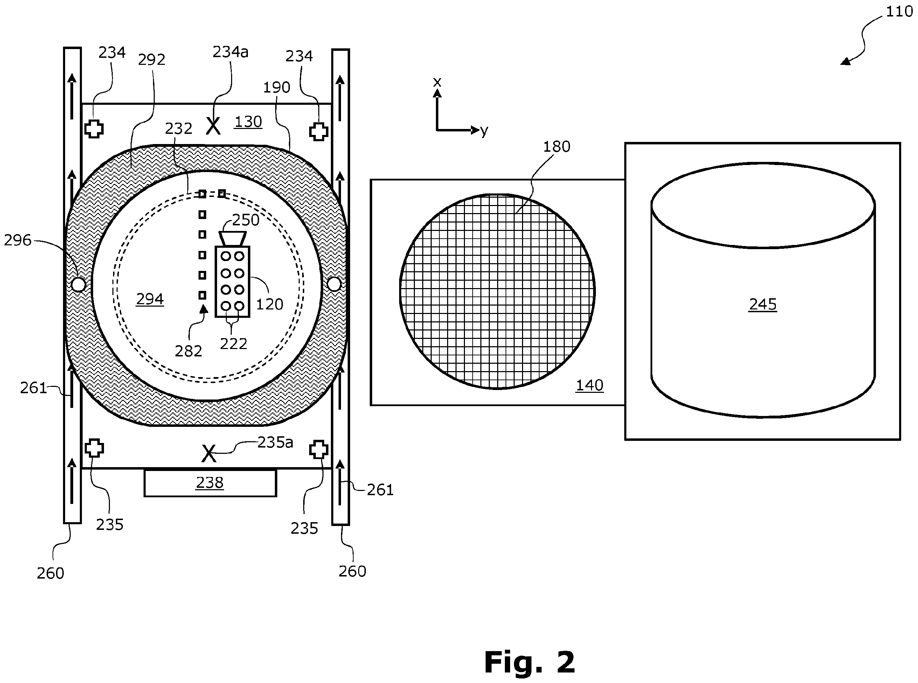

Der Aufbau und die Funktionsweise der Wafer-Aufnahmevorrichtung 130 wird im Folgenden anhand von Figur 2 im Detail erläutert.

Wie aus Figur 2 ersichtlich, weist die hier dargestellte Bestückmaschine 110 eine Transportvorrichtung 260 auf, welche gemäß dem hier dargestellten Ausführungsbeispiel zwei Transportschienen umfasst. Mittels der Transportvorrichtung 260 wird der zu bestückende Träger 190 auf die Träger-Aufnahmevorrichtung 130 transferiert und nach einem vollständigen Bestücken zum Zwecke einer weiteren Verarbeitung der Chips, insbesondere einer Herstellung von gehäusten Bauelementen mittels des bekannten "embedded Wafer Level Prozesses" (eWLP), abtransportiert. Die Transportrichtung der Transportvorrichtung 260 ist in Figur 2 mit Pfeilen illustriert, die mit dem Bezugszeichen 261 versehen sind.

Wie ferner aus Figur 2 ersichtlich, ist der Wafer-Zuführvorrichtung 140 ein Wafer-Speicher 245 zugeordnet, in welchem in nicht dargestellter Weise eine Mehrzahl von Wafern mit jeweils einer Vielzahl von ungehäusten Chips übereinander gestapelt angeordnet sind. Von der Wafer-Zufuhrvorrichtung 140 kann aus dem Wafer-Speicher 245 jeweils ein Wafer 180 entnommen und nach einem Bestücken der entsprechenden Chips der zumindest teilweise von Chips entleerte Wafer 180 wieder in den Wafer-Speicher 245 zurück gebracht werden.

Gemäß dem hier dargestellten Ausführungsbeispiel weist die TrägerAufnahmevorrichtung 130 eine Temperiervorrichtung 238 auf, welche dafür vorgesehen ist, zumindest die Oberfläche der Träger-Aufnahmevorrichtung 130, auf welcher Oberfläche sich der Wafer 190 befindet, auf einer zumindest annähernd konstanten Temperatur zu halten. Auf diese Weise können ungewollte thermische Verspannungen vermieden und eine hohe Positionsgenauigkeit des gesamten Trägers 190 gewährleistet werden.

Zum Fixieren des Trägers 190 weist die Träger-Aufnahmevorrichtung 130 an ihrer Oberfläche eine pneumatische Schnittstelle 232 auf, welche gemäß dem hier dargestellten Ausführungsbeispiel als eine um ein Zentrum der Träger-Aufnahmevorrichtung 130 herum umlaufende Nut 232 ausgebildet ist. In der Nut kann mit einer nicht dargestellten Vakuum-Erzeugungseinheit ein Unterdruck erzeugt werden, so dass die flächige Unterseite des Trägers 190 an der Träger-Aufnahmevorrichtung 130 angesaugt wird.

Für eine grobe Positionierung bzw. Zentrierung des Trägers 190 auf der Träger-Aufnahmevorrichtung 130 mittels der Transportvorrichtung 260 sind im Außenbereich des Trägers 190 zwei einander gegenüberliegende optische Strukturen 296 ausgebildet. Gemäß dem hier dargestellten Ausführungsbeispiel ist jede der beiden optischen Strukturen als ein einfaches Loch 296 ausgebildet.

Es wird darauf hingewiesen, dass der verwendete Träger ein herkömmlicher Träger 190 ist, welcher in bekannter Weise eine bevorzugt metallische Trägerplatte 292 sowie eine auf der Trägerplatte 292 aufgebrachte doppelseitige Klebefolie 294 aufweist. Auf diese Klebefolie 294 werden die Chips platziert, welche in Figur 2 mit dem Bezugszeichen 282 gekennzeichnet sind. Das Bestücken der Chips 282 erfolgt in bekannter Weise durch eine geeignete Positionierung des Bestückkopfes 120 sowie durch ein Absenken einer als Saugpipette ausgebildeten Chip-Halteeinrichtung 222 entlang der z-Richtung, welche senkrecht zu der Zeichenebene ist.

Die vorstehend beschriebene Zentrierung des Trägers 190 auf der Träger-Aufnahmevorrichtung 130 basiert auf einer optischen Vermessung der Positionen der Strukturen 296. Gemäß dem hier dargestellten Ausführungsbeispiel wird dazu eine Kamera 250 verwendet, welche auf vorteilhafte Weise an dem verfahrbaren Bestückkopf 120 angebracht ist und somit durch eine geeignete Ansteuerung des in Figur 2 nicht dargestellten Flächen-Positioniersystems in geeigneter Weise oberhalb der zu vermessenden Struktur 296 platziert werden kann. Sofern bei dieser Vermessung die Position der Kamera 250 innerhalb des Koordinatensystems der Bestückmaschine 110 bzw. des Flächen-Positioniersystems genau bekannt ist, können durch eine geeignete Bildauswertung eines von der Kamera 250 erfassten Bildes die Koordinaten des Trägers 190 in dem Koordinatensystem der Bestückmaschine 110 bestimmt werden.

Alternativ oder in Kombination können auch spezielle Markierungen 234, 235 verwendet werden, um die relative Position des Trägers in Bezug zu diesen Markierungen 234, 235 optisch zu bestimmen. Dazu ist es lediglich erforderlich, mit der Kamera 250 sowohl die optisch erkennbaren Strukturen 296 als auch zumindest zwei der Markierungen 234, 235 zu erfassen.

Es wird darauf hingewiesen, dass anhand einer Positionsvermessung der speziellen Markierungen 234, 235 auch eine ggf. vorhandenen Verzerrung des Flächen-Positioniersystems ermittelt und bei der Bestückung von Chips 282 in kompensierender Weise berücksichtigt werden kann. Wie bereits vorstehend im Detail erläutert, kann eine solche Verzerrung durch thermisch bedingte Verzüge von zumindest einer Komponente des Flächen-Positioniersystems verursacht werden.

Gemäß dem hier dargestellten Ausführungsbeispiel sind an der Träger-Aufnahmevorrichtung 130 zusätzlich noch eine Zwischenmarkierung 234a und eine weitere Zwischenmarkierung 235a angebracht. Durch eine Positionsvermessung dieser Markierungen kann die Genauigkeit insbesondere der Ermittlung der Verzerrung des Flächen-Positioniersystems erhöht werden.

Es wird darauf hingewiesen, dass die Markierungen 234, 235, 234a und/oder 235a hochgenaue innere Strukturen aufweisen, deren Positionen auf der Träger-Aufnahmevorrichtung 130 mit extrem hoher Genauigkeit bekannt sind. Dazu wird bevorzugt die Träger-Aufnahmevorrichtung 130 zusammen mit ihren Markierungen 234, 235, 234a und/oder 235a vor dem Einbau in die Bestückmaschine 110 mit einer hochgenauen optischen Messmaschine vermessen. Dadurch sind die Positionsdaten der Koordinaten der Markierungen 234, 235, 234a und/oder 235a genau bekannt, so dass diese Markierungen 234, 235, 234a und/oder 235a für eine hochgenaue Vermessung der Positionen der bestückten Chips 282 verwendet werden können.

Durch eine regelmäßige Vermessung der exakten Bestückpositionen können auftretende und gegebenenfalls mit der Zeit variierende Offsets in Bezug auf die Bestückposition erkannt und durch eine geeignete Ansteuerung des entsprechenden Flächen-Positioniersystems kompensiert werden.

Es wird darauf hingewiesen, dass der mit Chips 282 bestückte Träger 190 auch später außerhalb der Bestückmaschine 110 mit einer hochgenauen optischen Messmaschine (nicht dargestellt) vermessen werden kann. Auch aus den dadurch gewonnenen tatsächlichen Bestückpositionen kann für eine nachfolgende Bestückung von weiteren Trägern 190 das Flächen-Positioniersystemen in geeigneter Weise angesteuert werden, so dass die Chips 282 mit extrem hoher Genauigkeit auf dem zu bestückenden Träger 190 platziert werden können. Dies kann insbesondere auch im Rahmen einer Qualitätsüberprüfung der Bestückmaschine vor einer Auslieferung an einen Kunden durchgeführt werden.

Es wird ferner darauf hingewiesen, dass die Träger-Aufnahmevorrichtung 130 in mehreren unterschiedlichen Formaten bzw. Größen vorgehalten werden kann. Dadurch kann die Bestückmaschine 110 auf einfache Weise auf den Betrieb mit unterschiedlichen Träger-Formaten angepasst werden.

Anschaulich ausgedrückt kann die hier beschriebene Chip-Bestückmaschine 110 und einige ihrer Vorteile wie folgt zusammengefasst werden:
(A) Die Chip-Bestückmaschine 110 ist im Vergleich zu Bestückautomaten, welche für eine Bestückung von Leiterplatten mit gehäusten elektronischen Bauelementen verwendet werden, nicht nur mit zwei sondern mit mehr Markierungen 234 ausgestattet. Dadurch kann für jede mögliche Chip-Bestückposition mit hoher Genauigkeit ein Verzug bzw. ein Bestück-Offset bestimmt oder modelliert werden. Für diese Bestimmung kann ein erweitertes (bilineares) kinematisches Modell verwendet werden.
(B) Die Markierungen 234 können während des Betriebs der Bestückmaschine 110 zyklisch vermessen werden, um Veränderungen während der Verweilzeit des Trägers 190 in der Bestückmaschine 110 durch eine geeignete Ansteuerung des Flächen-Positioniersystems zu kompensieren.
(C) Die Temperiervorrichtung 238 ermöglicht eine Stabilisierung der Temperatur der Träger-Aufnahmevorrichtung 130, so dass damit automatisch auch der darauf aufliegende Träger 190 als Bestückmedium auf einer definierten konstanten Temperatur gehalten wird. Damit können während des Bestückens keine oder lediglich nur zu vernachlässigende thermische Veränderungen bzw. Verzüge auftreten.
(D) Die Position des zu bestückenden Trägers 190 muss nur zu Beginn einer Bestückung einmal relativ zu den Markierungen 234, 235, 234a und/oder 235a bestimmt werden. Durch die erfindungsgemäße feste pneumatische Fixierung des Trägers 190 auf der Träger-Aufnahmevorrichtung 130 wird der Träger 190 in dem Koordinatensystem der Bestückmaschine 110 in einer räumlich festen und genau definierten Position gehalten.

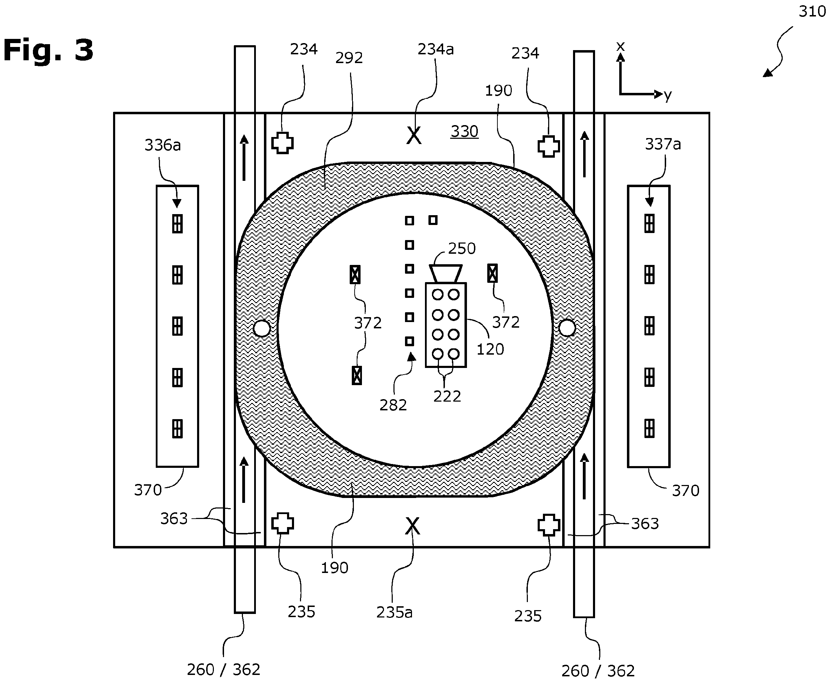

Figur 3 zeigt einen Teil einer Bestückmaschine 310 gemäß einem weiteren Ausführungsbeispiel der Erfindung. Die Bestückmaschine 310 weist eine Träger-Aufnahmevorrichtung 330 auf, welche im Vergleich zu der Träger-Aufnahmevorrichtung 130 entlang der y-Richtung deutlich breiter ist. Wie aus Figur 3 ersichtlich, erstreckt sich die Träger-Aufnahmevorrichtung 330 seitlich über die Transportvorrichtung 260 hinaus, deren Breite durch die entlang der γ-Richtung voneinander beabstandeten Transportspuren 362 bestimmt ist. Gemäß dem hier dargestellten Ausführungsbeispiel sind die beiden Transportspuren jeweils als ein Transportriemen 362 ausgebildet. Während eines Transportes des Trägers 190 entlang der x-Richtung liegen zwei einander gegenüberliegende Seitenbereiche des Trägers 190 auf jeweils einem der beiden Transportriemen 362 auf.

Die Träger-Aufnahmevorrichtung 330 weist ferner zwei längliche Transportnuten 363 auf, die unterhalb der beiden Transportriemen 362 ausgebildet sind. Während eines Transports des Trägers 190 haben zumindest die Abschnitte der beiden Transportriemen 362, auf welchen der Träger 190 aufliegt, senkrecht zur Zeichenebene eine Höhenlage, die oberhalb der Oberfläche der Träger-Aufnahmevorrichtung 330 ist. Zum pneumatischen Fixieren des Trägers 190 werden die beiden Transportriemen 362 abgesenkt, so dass sie sich innerhalb der beiden Transportnuten 363 befinden. Dieses Absenken der beiden Transportriemen 362 kann auf verschiedenste Art und Weise erfolgen, welche dem Fachmann, einem Konstrukteur auf dem Gebiet des Maschinenbaus, bekannt sind und deshalb an dieser Stelle nicht weiter erläutert werden.

In entsprechender Weise wird gemäß dem hier dargestellten Ausführungsbeispiel ein bestückter Träger 190 von der Träger-Aufnahmevorrichtung 330 abtransportiert, in dem die pneumatische Kopplung gelöst wird, die beiden Transportriemen 362 wieder angehoben werden und die Transportvorrichtung 260 aktiviert wird.

Wie aus Figur 3 ersichtlich, sind außerhalb des Bereiches, der durch die beiden Transportriemen 362 definiert ist, zwei Referenzelemente 370 an der Träger-Aufnahmevorrichtung 330 angebracht. Die beiden Referenzelemente 370 weisen jeweils mehrere Zusatzmarkierungen auf, wobei die Zusatzmarkierungen des in Figur 3 linken Referenzelements 370 mit dem Bezugszeichen 336a und weitere Zusatzmarkierungen des rechten Referenzelements 370 mit dem Bezugszeichen 337a versehen sind. Gemäß dem hier dargestellten Ausführungsbeispiel sind die Zusatzmarkierungen 336a bzw. die weiteren Zusatzmarkierungen 337a jeweils Teil eines hochpräzise gefertigten Maßstabes 370, welcher bevorzugt ein sogenannter Glasmaßstab 370 ist, welcher das betreffende Referenzelement 370 darstellt.

Die Zusatzmarkierungen 336a und/oder die weiteren Zusatzmarkierungen 337a können zusammen mit den anderen und vorstehend anhand von Figur 2 bereits erläuterten Markierungen 234, weiteren Markierungen 235, Zwischenmarkierungen 234a und/oder weiteren Zwischenmarkierungen 235a dazu verwendet werden, basierend auf einer optischen Vermessung mit der Kamera 250 eine gegebenenfalls vorhandene Verzerrung des Flächen-Positioniersystems zu bestimmen, mittels welchem der Bestückkopf 120 in bekannter Weise innerhalb der xy-Ebene Verfahren werden kann. Eine solche Verzerrung kann, wie vorstehend bereits erwähnt, durch thermisch bedingte Verformungen von zumindest einigen Komponenten (vgl. die Bezugszeichen 114, 116, 118 in Figur 1) des Flächen-Positioniersystems verursacht werden und sich bei Temperaturschwankungen im Verlauf des Betriebs der Bestückmaschine 310 ändern.

Es wird darauf hingewiesen, dass die Zusatzmarkierungen 336a und/oder die weiteren Zusatzmarkierungen 337a insbesondere dafür sorgen können, dass eine Dehnung, eine Stauchung und/oder eine Verbiegung, beispielsweise eine S-förmige Verbiegung, des verfahrbaren querstehenden Trägerarms 116 identifiziert und bei der Positionierung des Bestückkopfes 120 kompensiert werden können.

Mit der Bestückmaschinen 310 kann ferner eine Veränderung eines beispielsweise thermisch bedingten Verzuges des Flächen-Positioniersystems erkannt werden. Eine solche Veränderung des Verzug bzw. der Verzerrung des Flächen-Positioniersystems kann sich während der Bestückung des Trägers 190 mit ungehäusten Chips 282, welche Bestückung beispielsweise 1 bis 2 Stunden dauern kann, auftreten. Gemäß dem hier dargestellten Ausführungsbeispiel erfolgt dies anhand einer Bestückung von sogenannten Kalibrierbausteinen 372, deren Position in dem Koordinatensystem des Flächen-Positioniersystems mittels der Kamera 222 zyklisch vermessen wird. Dadurch kann eine gegebenenfalls auftretende Positionsveränderung der Kalibrierbausteine 372 (in dem Koordinatensystem des Flächen-Positioniersystems) erkannt und daraus ggf. eine geänderte Verzerrung (des Koordinatensystems des Flächen-Positioniersystems) bestimmt und bei der Bestückung von weiteren Chips 282 in kompensierender Weise berücksichtigt werden.

Die Kalibrierbausteine 372 können insbesondere aus einem Glasmaterial mit einer extrem geringen thermischen Ausdehnung bestehen und demzufolge als Glasbausteine bezeichnet werden. An den Kalibrierbausteinen 372 können ferner optisch gut erkennbare und feine Strukturen hinsichtlich ihrer Position und Form hochpräzise angebracht bzw. ausgebildet sein, welche für die beschriebene optische Vermessung verwendet werden und infolge ihrer Präzision eine extrem genaue Bestimmung der Verzerrung des Koordinatensystems des Flächen-Positioniersystems ermöglichen.

### BEZUGSZEICHEN:

- 100: Bestücksystem
- 110: Bestückmaschine
- 112: Chassis
- 114: erste Komponente / stationäre Trägerschiene
- 116: zweite Komponente / verfahrbarer querstehender Trägerarm
- 118: dritte Komponente / verfahrbare Trägerplatte
- 120: Bestückkopf
- 121: weitere Bestückkopf
- 130: Träger-Aufnahmevorrichtung
- 140: Wafer-Zuführvorrichtung
- 141: weitere Wafer-Zuführvorrichtung
- 180: Wafer
- 190: Träger

- 222: Chip-Halteeinrichtungen / Saugpipetten
- 232: pneumatische Schnittstelle / umlaufende Nut
- 234: Markierungen
- 234a: Zwischenmarkierung
- 235: weitere Markierungen
- 235a: weitere Zwischenmarkierung
- 238: Temperiervorrichtung
- 245: Wafer-Speicher
- 250: Kamera
- 260: Transportvorrichtung
- 261: Transportrichtung
- 282: Chips (bestückt)
- 292: Trägerplatte
- 294: Klebefolie
- 296: optisch erkennbare Struktur / Loch
- 310: Bestückmaschine
- 330: Träger-Aufnahmevorrichtung
- 336a: Zusatzmarkierungen
- 337a: weitere Zusatzmarkierungen
- 362: Transportspuren / Transportriemen
- 363: Transportnuten
- 370: Referenzelement / Glasmaßstab
- 372: Kalibrierbausteine

## Patentansprüche

1. Bestückmaschine zum Bestücken eines Trägers (190) mit ungehäusten Chips (282), insbesondere zum Zwecke des Herstellens von elektronischen Bauelementen, welche jeweils zumindest einen Chip (282) aufweisen, der sich in einem Gehäuse befindet, welches insbesondere eine ausgehärtete Vergussmasse aufweist, die Bestückmaschine (110) aufweisend
eine Zuführeinrichtung (140) zum Bereitstellen eines Wafers (180), der eine Vielzahl von Chips (282) aufweist;
eine Träger-Aufnahmevorrichtung (130) zum Aufnehmen des zu bestückenden Trägers (190);
einen Bestückkopf (120) zum Abholen von Chips (282) von dem bereitgestellten Wafer (180) und zum Platzieren der abgeholten Chips (282) an vordefinierten Bestückpositionen auf dem Träger (190);
wobei die Träger-Aufnahmevorrichtung (130) eine pneumatische Schnittstelle (232) aufweist, mittels welcher ein Unterdruck an eine Oberfläche des Trägers (190) anlegbar ist;
**dadurch gekennzeichnet, dass** die Bestückmaschine ferner aufweist eine Temperiervorrichtung (238), welche thermisch mit der Träger-Aufnahmevorrichtung (130) gekoppelt ist und welche eingerichtet ist, die Träger-Aufnahmevorrichtung (130) zumindest annähernd auf einer konstanten Temperatur zu halten,
wobei die Temperiervorrichtung (238) eingerichtet ist, die Träger-Aufnahmevorrichtung (130) zu kühlen, so dass diese eine Temperatur annehmen kann, die um zumindest 2 Kelvin niedriger ist als die unmittelbare Umgebungstemperatur der Träger-Aufnahmevorrichtung (130).

2. Bestückmaschine gemäß dem vorangehenden Anspruch, wobei
die pneumatische Schnittstelle eine Nut (232) aufweist, welche mit dem Unterdruck beaufschlagt werden kann, der von einer Unterdruck-Erzeugungseinheit erzeugt wird.

3. Bestückmaschine gemäß Anspruch 1 oder 2, wobei
die Temperiervorrichtung (238) eingerichtet ist, die Träger-Aufnahmevorrichtung (130) zu kühlen, so dass diese eine Temperatur annehmen kann, die um zumindest 4 Kelvin und insbesondere um zumindest 7 Kelvin niedriger ist als die unmittelbare Umgebungstemperatur Träger-Aufnahmevorrichtung (130).

4. Bestückmaschine gemäß einem der vorangehenden Ansprüche, ferner aufweisend
ein Chassis (112); und
ein Positioniersystem (114, 116, 118), welches aufweist
- eine erste Komponente (114), die in Bezug zu dem Chassis (112) stationär angeordnet ist,
- eine zweite Komponente (116), die in Bezug zu der ersten Komponente (114) entlang einer vorgegebenen ersten Richtung (y) verfahrbar ist, und
- eine dritte Komponente (118), die in Bezug zu der zweiten Komponente (116) entlang einer vorgegebenen zweiten (x) Richtung verfahrbar ist;
wobei der Bestückkopf (120) an der dritten Komponente (118) befestigt ist und wobei die erste Richtung (y) winklig zu der zweiten Richtung (x) ist.

5. Bestückmaschine gemäß dem vorangehenden Anspruch, wobei
die Träger-Aufnahmevorrichtung (130) zumindest zwei Markierungen (234) aufweist, welche optisch erkennbar sind und welche insbesondere außerhalb eines räumlichen Bereiches an der Träger-Aufnahmevorrichtung (130) angebracht sind, welcher Bereich für die Aufnahme des Trägers (190) vorgesehen ist.

6. Bestückmaschine gemäß dem vorangehenden Anspruch, wobei
die Träger-Aufnahmevorrichtung (130) zumindest zwei weitere Markierungen (235) aufweist, welche optisch erkennbar sind und welche insbesondere außerhalb eines räumlichen Bereiches an der Träger-Aufnahmevorrichtung (130) angebracht sind, welcher Bereich für die Aufnahme des Trägers (190) vorgesehen ist, wobei insbesondere
die Bestückmaschine **dadurch gekennzeichnet ist, dass**
die beiden Markierungen (234) relativ zueinander einen räumlichen Versatz entlang der ersten Richtung (y) haben,
die beiden weiteren Markierungen (235) relativ zueinander einen räumlichen Versatz entlang der ersten Richtung (y) haben, und
jede der beiden Markierungen (234) relativ zu jeder der beiden weiteren Markierungen (235) einen räumlichen Versatz entlang der zweiten Richtung (x) hat.

7. Bestückmaschine gemäß dem vorangehenden Anspruch,
wobei die Träger-Aufnahmevorrichtung (130) ferner zumindest
eine Zwischenmarkierung (234a) aufweist, welche sich entlang der ersten Richtung (y) zwischen den beiden Markierungen (234) befindet, und/oder
wobei die Träger-Aufnahmevorrichtung (130) ferner zumindest
eine weitere Zwischenmarkierung (235a) aufweist, welche sich entlang der ersten Richtung (y) zwischen den beiden weiteren Markierungen (235) befindet, wobei insbesondere
die Bestückmaschine **dadurch gekennzeichnet ist, dass**
an der Träger-Aufnahmevorrichtung (130) zumindest
eine Zusatzmarkierung (336a) angebracht ist, welche sich entlang der zweiten Richtung (x) zwischen einer Markierung (234) und einer weiteren Markierung (235) befindet, und/oder
an der Träger-Aufnahmevorrichtung (130) ferner zumindest
eine weitere Zusatzmarkierung (337a) angebracht ist, welche sich entlang der zweiten Richtung (x) zwischen einer Markierung (234) und einer weiteren Markierung (235) befindet.

8. Bestückmaschine gemäß dem vorangehenden Anspruch, ferner aufweisend
eine Transportvorrichtung (260) zum Zuführen von zu bestückenden Trägern (190) zu der Träger-Aufnahmevorrichtung (130) und zum Abführen von zumindest teilweise mit ungehäusten Chips bestückten Trägern (190) von der Träger-Aufnahmevorrichtung (130),
wobei die Transportvorrichtung (260) zwei Transportspuren (362) aufweist, welche sich entlang der zweiten Richtung (x) erstrecken und entlang der ersten Richtung (y) voneinander beabstandet sind und welche ausgebildet sind, einen Träger (190) an zwei Seiten zu halten, und
wobei die zumindest eine Zusatzmarkierung (336a) und/oder die zumindest eine weitere Zusatzmarkierung (337a) außerhalb der beiden Transportspuren (362) angeordnet sind, wobei insbesondere
die Bestückmaschine **dadurch gekennzeichnet ist, dass**
die beiden Transportspuren jeweils als ein Transportriemen (362) ausgebildet sind und
in der Träger-Aufnahmevorrichtung (130) zwei Transportnuten (363) ausgebildet sind, welche entlang der zweiten Richtung (x) verlaufen und räumlich derart ausgebildet sind, dass in jeder Transportnut (363) jeweils ein Transportriemen (362) versenkbar ist, wobei weiter insbesondere
die Bestückmaschine aufweist
ein Referenzelement (370), welches an der Träger-Aufnahmevorrichtung (130) befestigt ist,
wobei die zumindest eine Zusatzmarkierung (336a) und/oder die zumindest eine weitere Zusatzmarkierung (337a) an dem Referenzelement (370) angebracht sind.

9. Bestückmaschine gemäß einem der vorangehenden Ansprüche 5 bis 8, ferner aufweisend
eine Kamera (250), welche derart positioniert oder positionierbar ist, dass zumindest eine der Markierungen (234) und auf den Träger (190) bestückte Chips (282) gemeinsam in einem Bild von der Kamera (250) aufgenommen werden können,
wobei insbesondere
die Kamera (250) relativ zu dem Bestückkopf (120) in einer räumlich festen Position angeordnet ist, wobei weiter insbesondere
der Bestückkopf (120) eine Mehrzahl von Haltevorrichtungen (222) zum temporären Aufnehmen von jeweils einem Chip (282) aufweist.

10. Bestückmaschine gemäß einem der vorangehenden Ansprüche, ferner aufweisend
eine weitere Zuführeinrichtung (141) zum Bereitstellen eines weiteren Wafers (180), der ebenfalls eine Vielzahl von Chips (282) aufweist; und
einen weiteren Bestückkopf (121) zum Abholen von Chips (282) von dem bereitgestellten weiteren Wafer (180) und zum Platzieren der abgeholten Chips (282) an vordefinierten Bestückpositionen auf dem Träger (190).

11. Verfahren zum Bestücken eines Trägers (190) mit ungehäusten Chips (282) mit einer Bestückmaschine (110) gemäß einem der vorangehenden Ansprüche, das Verfahren aufweisend
Bereitstellen eines Wafers (180), der eine Vielzahl von Chips (282) aufweist, mittels einer Zuführeinrichtung (140);
Aufnehmen des zu bestückenden Trägers mittels einer Träger-Aufnahmevorrichtung (130);
Fixieren des zu bestückenden Trägers (190) an der Träger-Aufnahmevorrichtung (130) mittels eines Unterdrucks, welcher über eine pneumatische Schnittstelle (232) der Träger-Aufnahmevorrichtung (130) an eine Oberfläche des Trägers (190) angelegt wird;
Abholen von bereitgestellten Chips (282) von der Zuführeinrichtung (140) mittels eines Bestückkopfes (120);
Transportieren der abgeholten Chips (282) hin zu einem Bestückbereich; und
Aufsetzen der transportierten Chips (282) an vorbestimmten Bestückpositionen auf dem Träger (190).

12. Verfahren gemäß dem vorangehenden Anspruch, wobei
der Träger (190) eine Platte (292) und Klebefolie (294) aufweist, welche an einer flächigen Oberseite auf der Platte (292) aufgebracht ist, wobei das Verfahren insbesondere ferner aufweist
Zuführen des Trägers (190) zu der Träger-Aufnahmevorrichtung (130) mittels einer Transportvorrichtung (260);
Erfassen der Positionen von zwei optischen Strukturen (296), welche sich an dem zugeführten Träger (190) befinden;
Bestimmen der Position des zugeführten Trägers (190) basierend auf den erfassten Positionen; und
Ermitteln der Koordinaten der vorbestimmten Bestückpositionen in einem Koordinatensystem der Bestückmaschine (110) basierend auf der bestimmten Position des zugeführten Trägers (190);
wobei die vorbestimmten Bestückpositionen auf dem Träger (190) von den ermittelten Koordinaten abhängen.

13. Verfahren gemäß einem der zwei vorangehenden Ansprüche, ferner aufweisend
Erfassen der Positionen von mindestens zwei Markierungen (234), welche sich an der Träger-Aufnahmevorrichtung (130) befinden;
wobei die vorbestimmten Bestückpositionen auf dem Träger (190) ferner von den Positionen der mindestens zwei Markierungen (234) abhängen,
wobei insbesondere
die Positionen der Markierungen (234) an der Träger-Aufnahmevorrichtung (130) während des Bestückens eines Trägers (190) in vorgegebenen zeitlichen Abständen wiederholt erfasst werden und die Koordinaten der vorbestimmten Bestückpositionen basierend auf den erfassten Positionen korrigiert werden.

14. Verfahren gemäß einem der drei vorangehenden Ansprüche, ferner aufweisend
Vermessen der Position von einer auf den Träger (190) bestückten Struktur;
erneutes Vermessen der Position von der Struktur zu einem späteren Zeitpunkt während des Bestückens des Trägers (190) mit ungehäusten Chips (282); und
Bestimmen einer relativen Positionsverschiebung der Struktur zwischen dem Vermessen und dem erneuten Vermessen;
wobei die vorbestimmten Bestückpositionen auf dem Träger (190) ferner von der Positionsverschiebung der Struktur abhängen, wobei insbesondere die Struktur eine optisch erkennbare Struktur von einem bestückten Kalibrierbaustein (372) ist oder eine optisch erkennbare Struktur von einem bestückten ungehäusten Chip (282) ist.

## Claims

1. Assembling machine for assembling a carrier (190) with bare chips (282), in particular for the purpose of producing electronic components, which each comprise at least one chip (282), which is placed in a housing, which comprises in particular a hardened casting compound, the assembling machine (110) comprising
a feeding device (140) for providing a wafer (180), which comprises a plurality of chips (282);
a carrier receiving device (130) for receiving the carrier (190) to be assembled;
an assembling head (120) for collecting chips (282) from the provided wafer (180) and for placing the collected chips (282) at predefined assembling positions on the carrier (190);
wherein the carrier receiving device comprises a pneumatic interface (232), with which an underpressure may be applied to a surface of the carrier (190); **characterized in that** the assembling machine further comprises a tempering device (238), which is thermally coupled with the receiving device (130) and which is configured to keep the carrier receiving device (130) at least approximately at a constant temperature,
wherein the tempering device (238) is configured to cool the carrier receiving device (130), so that it can adopt a temperature that is at least lower by 2 Kelvin than the proximate ambient temperature of the carrier receiving device (130).

2. Assembling machine according to the preceding claim, wherein
the pneumatic interface comprises a notch (232), to which the underpressure can be applied, which is generated by an underpressure generating unit.

3. Assembling machine according to claim 1 or 2, wherein the tempering device (238) is configured to cool the carrier receiving device (130), so that that it can adopt a temperature that is at least by 4 Kelvin lower and in particular at least by 7 Kelvin lower than the proximate ambient temperature of the carrier receiving device (130).

4. Assembling machine according to one of the preceding claims, further comprising
a chassis (112); and
a positioning system (114, 116, 118), which comprises
- a first component (114), which, with regard to the chassis (112), is arranged in a stationary manner,
- a second component (116), which, with regard to the first component (114), is movable along a predetermined first direction (y), and
- a third component (118), which, with regard to the second component (116), is movable along a predetermined second direction (x);
wherein the assembling head (120) is fixed to the third component (118) and wherein the first direction (y) is at an angle to the second direction (x).

5. Assembling machine according to the preceding claim, wherein
the carrier receiving device (130) comprises at least two markings (234), which are optically identifiable, and which in particular are fixed outside of a spatial region to the carrier receiving device (130), which region is provided for receiving the carrier (190).

6. Assembling machine according to the preceding claim, wherein
the carrier receiving device (130) comprises at least two further markings (235), which are optically identifiable and which are in particular outside of a spatial region fixed to the carrier receiving device (130), which region is provided for receiving the carrier (190), wherein, in particular, the assembling machine is **characterized in that**
both markings (234) have, relative to each other, a spatial offset along in the first direction (y),
both further markings (235) have, relative to each other, a spatial offset along the first direction (y), and
each of the both markings (234) have relative to each of the both further markings (235) a spatial offset along the second direction (x).

7. Assembling machine according to the preceding claim, wherein
the carrier receiving device (130) further comprises at least an intermediate marking (234a), which is arranged along the first direction (y) between the both markings (234), and/or wherein the carrier receiving device further comprises at least a further intermediate marking (235a), which is arranged along the first direction (y) between the both further markings (235), wherein, in particular, the assembling machine is **characterized in that**
at the carrier receiving device (130) at least
one additional marking (336a) is fixed, which is arranged along the second direction (x) between a marking (234) and a further marking (235), and/or
at the carrier receiving device (130) further at least
one further additional marking (337a) is fixed, which is arranged along the second direction (x) between a marking (234) and a further marking (235).

8. Assembling machine according to the preceding claim, further comprising a transport device (260) for feeding carriers (190) to be assembled to the carrier receiving device (130) and for discharging carriers (190) which are at least partially assembled with bare chips from the carrier receiving device (130), wherein
the transport device (260) comprises two transport lanes (362), which extend along the second direction (x) and which are, along the first direction (y), spaced apart from each other and which are formed to hold a carrier (190) on two sides, and
wherein the at least one additional marking(336a) and/or the at least one further additional marking (337a) are arranged outside of both transport lanes (362), wherein, in particular, the assembling machine is **characterized in that** the both transport lanes are each formed as a transport belt (362) and
in the carrier receiving device (130) there are formed two transport notches (363), which run along the second direction (x) and which are spatially formed in such a way, that into each transport notch (363) one respective transport belt (362) is countersinkable, wherein, further in particular, the assembling machine comprises
a reference element (370), which is fixed to the carrier receiving device (130), wherein the at least one additional marking (336a) and/or the at least one further additional marking (337a) are fixed to the reference element (370).

9. Assembling machine according to one of the preceding claims 5 to 8, further comprising
a camera (250), which is positioned or positionable in such a way, that at least one of the markings (234) and chips (282) assembled on the carrier (190) can be recorded by the camera (250) together in one image,
wherein, in particular,
relative to the assembling head (120), the camera (250) is arranged in a spatially fixed position, wherein, further in particular,
the assembling head (120) comprises a plurality of holding devices (222) for temporarily receiving one chip (282) each.

10. Assembling machine according to one of the preceding claims, further comprising
a further feeding device (141) for providing a further wafer (180), which also comprises a plurality of chips (282); and
a further assembling head (121) for collecting chips (282) from the provided further wafers (180) and for placing the collected chips (282) at predefined assembling positions on the carrier (190).

11. Method for assembling a carrier (190) with bare chips (282) with an assembling machine (110) according to one of the preceding claims, the method comprising
providing a wafer (180) which comprises a plurality of chips (282), by means of a feeding device (140);
receiving the carrier to be assembled by means of a carrier receiving device (130);
fixing the assembled carrier (190) to the carrier receiving device (130) by means of an underpressure, which is applied by means of pneumatic interface (232) of the carrier receiving device (130) to a surface of the carrier (190);
collecting provided chips (282) from the feeding device (140) by means of an assembling head (120);
transporting the collected chips (282) to an assembly region; and
placing the transported chips (282) at predetermined assembly positions on the carrier (190).

12. Method according to the preceding claim, wherein the carrier (190) comprises a plate (292) and adhesive foil (294), which is applied to a planar top side on the plate (292), wherein the method in particular further comprises
feeding the carrier (190) to the carrier receiving device (130) by means of a transport device (260);
capturing the positions of two optical structures (296), which are arranged at the fed carrier (190);
determining the position of the fed carrier (190) based on the captured positions; and
identifying the coordinates of the predetermined assembling positions in a coordinate system of the assembling machine (110) based on the determined position of the fed carrier (190);
wherein the predetermined assembling positions on the carrier (190) depend on the identified coordinates.

13. Method according to one of the two preceding claims, further comprising
capturing the positions of at least two markings (234) which are arranged at the carrier receiving device (130);
wherein the predetermined assembling positions on the carrier (190) further depend on the positions of the at least two markings (234),
wherein, in particular,
the positions of the markings (234) at the carrier receiving device (130) during the assembling of a carrier (190) in given time intervals are repeatedly captured and the coordinates of the predetermined assembling positions based on the captured positions are corrected.

14. Method according to one of the three preceding claims, further comprising
measuring the position of a structure assembled to the carrier (190);
re-measuring the position of the structure at a later instant of time during assembling the carrier (190) with bare chips (282); and
determining a relative shift of position of the structure between the measuring and the re-measuring;
wherein the predetermined assembling positions on the carrier (190) further depend further on the shift of position of the structure, wherein, in particular, the structure is an optically identifiable structure of an assembled calibrating component (372) or an optically identifiable structure of an assembled bare chip (282).

## Revendications

1. Machine d'implantation pour implanter dans un support (190) des puces sans boîtier (282), en particulier afin de fabriquer des composants électroniques, lesquels présentent respectivement au moins une puce (282) qui se trouve dans un boîtier, lequel présente en particulier une masse de scellement durcie, la machine d'implantation (110) présentant
un dispositif d'alimentation (140) pour fournir une tranche (180) qui présente une pluralité de puces (282) ;
un dispositif de réception de support (130) pour loger le support à équiper (190) ;
une tête d'implantation (120) pour faire ramasser la puce (282) par la tranche fournie (180) et pour mettre en place la puce ramassée (282) dans des positions d'implantation prédéfinies sur le support (190) ;
dans laquelle le dispositif de réception de support (130) présente une interface pneumatique (232) au moyen de laquelle une dépression peut être établie au niveau d'une surface du support (190) ;
**caractérisée en ce que** la machine d'implantation présente en outre un dispositif de régulation thermique (238), lequel est couplé thermiquement avec le dispositif de réception de support (130) et lequel est conçu pour maintenir le dispositif de réception de support (130) au moins à peu près à une température constante,
dans laquelle le dispositif de régulation thermique (238) est conçu pour refroidir le dispositif de réception de support (130) de sorte que celui-ci peut adopter une température qui est inférieure d'au moins 2 kelvin à la température ambiante immédiate du dispositif de réception de support (130).

2. Machine d'implantation selon la revendication précédente, **caractérisée en ce que** l'interface pneumatique présente une rainure (232), laquelle peut être soumise à la dépression qui est générée par une unité de génération de dépression.

3. Machine d'implantation selon la revendication 1 ou 2, **caractérisée en ce que** le dispositif de régulation thermique (238) est conçu pour refroidir le dispositif de réception de support (130) de sorte que celui-ci peut adopter une température qui est inférieure d'au moins 4 kelvin et en particulier d'au moins 7 kelvin à la température ambiante immédiate du dispositif de réception de support (130).

4. Machine d'implantation selon l'une des revendications précédentes, présentant en outre
un châssis (112) ; et
un système de positionnement (114, 116, 118) lequel présente
- un premier composant (114) qui est disposé de manière stationnaire par rapport au châssis (112),
- un deuxième composant (116) qui est mobile par rapport au premier composant (114) le long d'une première direction prédéfinie (y), et
- un troisième composant (118) qui est mobile par rapport au deuxième composant (116) le long d'une seconde direction prédéfinie (x) ;
**caractérisée en ce que** la tête d'implantation (120) est fixée au troisième composant (118) et dans laquelle la première direction (y) forme un angle avec la seconde direction (x).

5. Machine d'implantation selon l'une des revendications précédentes, **caractérisée en ce que** le dispositif de réception de support (130) présente au moins deux repères (234), lesquels sont reconnaissables optiquement et lesquels sont en particulier installés au niveau du dispositif de réception de support (130) à l'extérieur d'une région spatiale, laquelle région est prévue pour la réception du support (190).

6. Machine d'implantation selon la revendication précédente, dans laquelle le dispositif de réception de support (130) présente au moins deux autres repères (235), lesquels sont reconnaissables optiquement et lesquels sont en particulier installés au niveau du dispositif de réception de support (130) à l'extérieur d'une région spatiale, laquelle région est prévue pour la réception du support (190), dans laquelle en particulier
la machine d'implantation est **caractérisée en ce que**
les deux repères (234) ont l'un par rapport à l'autre un décalage spatial le long de la première direction (y),
les deux autres repères (235) ont l'un par rapport à l'autre un décalage spatial le long de la première direction (y), et
chacun des deux repères (234) a par rapport à chacun des deux autres repères (235) un décalage spatial le long de la seconde direction (x).

7. Machine d'implantation selon la revendication précédente,
dans laquelle le dispositif de réception de support (130) présente en outre au moins un repère intermédiaire (234a), lequel se trouve le long de la première direction (y) entre les deux repères (234), et/ou dans lequel le dispositif de réception de support (130) présente en outre au moins un autre repère intermédiaire (235a), lequel se trouve le long de la première direction (y) entre les deux autres repères (235), dans laquelle en particulier
la machine d'implantation est **caractérisée en ce que**
au niveau du dispositif de réception de support (130) est installé au moins un repère supplémentaire (336a), lequel se trouve le long de la seconde direction (x) entre un repère (234) et un autre repère (235), et/ou
au niveau du dispositif de réception de support (130) en outre au moins
un autre repère supplémentaire (337a) est installé, lequel se trouve le long de la seconde direction (x) entre un repère (234) et un autre repère (235).

8. Machine d'implantation selon la revendication précédente, présentant en outre
un dispositif de transport (260) pour alimenter le dispositif de réception de support (130) en supports à implanter (190) et pour évacuer au moins partiellement du dispositif de réception de support (130) des supports (190) dans lesquels ont été implantées des puces sans boîtier,
dans laquelle le dispositif de transport (260) présente deux pistes de transport (362), lesquelles s'étendent le long de la seconde direction (x) et le long de la première direction (y) à distance l'une de l'autre et lesquelles sont réalisées pour maintenir un support (190) au niveau de deux faces, et
dans laquelle au moins un repère supplémentaire (336a) et/ou au moins un autre repère supplémentaire (337a) sont disposés à l'extérieur des deux pistes de transport (362), dans laquelle en particulier
la machine d'implantation est **caractérisée en ce que**
les deux pistes de transport sont respectivement réalisées en tant que courroie de transport (362) et
dans le dispositif de réception de support (130) sont réalisées deux rainures de transport (363), lesquelles courent le long de la seconde direction (x) et sont réalisées dans l'espace de sorte que dans chaque rainure de transport (363) une courroie de transport (362) est respectivement escamotable, dans laquelle en outre en particulier
la machine d'implantation présente
un élément de référence (370), lequel est fixé au dispositif de réception de support (130),
dans laquelle au moins un repère supplémentaire (336a) et/ou au moins un autre repère supplémentaire (337a) sont installés au niveau de l'élément de référence (370) .

9. Machine d'implantation selon l'une des revendications 5 à 8, présentant en outre
une caméra (250), laquelle est positionnée ou positionnable de sorte qu'au moins l'un des repères (234) et des puces (282) implantées sur le support (190) peuvent être capturés en commun dans une image par la caméra (250),
**caractérisée en ce qu'**en particulier
la caméra (250) est disposée par rapport à la tête d'implantation (120) dans une position fixe dans l'espace, dans laquelle en outre en particulier
la tête d'implantation (120) présente une pluralité de dispositifs de maintien (222) pour une réception temporaire de respectivement une puce (282).

10. Machine d'implantation selon l'une des revendications précédentes, présentant en outre
un dispositif d'alimentation supplémentaire (141) pour fournir une autre tranche (180) qui présente également une pluralité de puces (282) ; et
une autre tête d'implantation (121) pour faire ramasser des puces (282) par l'autre tranche fournie (180) et pour mettre en place la puce ramassée (282) dans des positions d'implantation prédéfinies sur le support (190).

11. Procédé pour l'implantation de puces sans boîtier (282) dans un support (190) avec une machine d'implantation (110) selon l'une des revendications précédentes, le procédé présentant
la fourniture d'une tranche (180) qui présente une pluralité de puces (282) au moyen d'un dispositif d'alimentation (140) ;
la réception du support à implanter au moyen d'un dispositif de réception de support (130) ;
la fixation du support à implanter (190) au niveau du dispositif de réception de support (130) au moyen d'une dépression, laquelle est établie au niveau d'une surface du support (190) par le biais d'une interface pneumatique (232) du dispositif de réception de support (130) ;
le ramassage de puces fournies (282) par le dispositif d'alimentation (140) au moyen d'une tête d'implantation (120) ;
le transport des puces ramassées (282) vers une région d'implantation ; et
la pose des puces transportées (282) au niveau de positions d'implantation prédéterminées sur le support (190) .

12. Procédé selon la revendication précédente, **caractérisé en ce que**
le support (190) présente une plaque (292) et un film adhésif (294), lequel est appliqué au niveau d'une face supérieure plate sur la plaque (292), dans lequel le procédé présente en particulier en outre
l'alimentation du dispositif de réception de support (130) avec le support (190) au moyen d'un dispositif de transport (260) ;
la détection des positions de deux structures optiques (296), lesquelles se trouvent au niveau du support alimenté (190) ;
la détermination de la position du support alimenté (190) en se basant sur les positions détectées ; et
la communication des coordonnées des positions d'implantation prédéterminées dans un système de coordonnées de la machine d'implantation (110) en se basant sur la position déterminée du support alimenté (190) ;
dans lequel les positions d'implantation prédéterminées sur le support (190) dépendent des coordonnées communiquées.

13. Procédé selon l'une des deux revendications précédentes, présentant en outre
la détection des positions d'au moins deux repères (234), lesquels se trouvent au niveau du dispositif de réception de support (130) ;
**caractérisé en ce que** les positions d'implantation prédéterminées sur le support (190) dépendent en outre des positions d'au moins deux repères (234),
dans lequel en particulier
les positions des repères (234) au niveau du dispositif de réception de support (130) sont détectées de manière répétée pendant l'implantation d'un support (190) dans des intervalles de temps prédéfinis et les coordonnées des positions d'implantation prédéterminées sont corrigées en se basant sur les positions détectées.

14. Procédé selon l'une des trois revendications précédentes, présentant en outre
le relevé de la position d'une structure implantée sur le support (190) ;
le relevé renouvelé de la position de la structure à un moment ultérieur pendant l'implantation de puces sans boîtier (282) dans le support (190) ;
la détermination d'un déplacement de position relatif de la structure entre le relevé et le relevé renouvelé ;
**caractérisé en ce que** les positions d'implantation prédéterminées sur le support (190) dépendent en outre du déplacement de position de la structure, dans lequel en particulier la structure est une structure optiquement reconnaissable d'un composant d'étalonnage (372) ou est une structure optiquement reconnaissable d'une puce sans boîtier implantée (282).
